# EUROPEAN PATENT SPECIFICATION

(11) **EP 1 270 762 B1**
(45) Date of publication and mention of the grant of the patent: **24.05.2006**
(21) Application number: 02252664.4
(22) Date of filing: 15.04.2002
(51) Int. Cl.: C23C 16/40, C23C 16/50, C23C 16/56

(54) **PECVD of optical quality silica films**
PECVD von Siliciumdioxidfilmen von optischer Qualität
PECVD de couches d'oxide de silicium de qualité optique

(30) Priority: 13.04.2001 US 833711
(43) Date of publication of application: 02.01.2003
(73) Proprietor: Dalsa Semiconductor Inc., Waterloo, Ontario N2V 2E9 (CA)
(72) Inventor: Ouellet, Luc, Quebec J2H 2R8 (CA); Grondin, Manuel, Quebec J2J 1E3 (CA); LaChance, Jonathan, Quebec J2G 9C9 (CA); Blain, Stephane, Quebec J1K 2N6 (CA)
(74) Representative: Harding, Richard Patrick

(56) References cited:
- EP-A- 0 624 660
- EP-A- 0 935 284
- US-A- 4 394 401
- US-A- 5 861 197
- US-A- 5 904 491
- US-A- 5 976 991
- US-A- 5 979 188
- WU T H T ET AL: "STRESS IN PSG AND NITRIDE FILMS AS RELATED TO FILM PROPERTIES AND ANNEALING" SOLID STATE TECHNOLOGY, COWAN PUBL.CORP. WASHINGTON, US, vol. 35, no. 5, 1 May 1992 (1992-05-01), pages 65-72, XP000277405 ISSN: 0038-111X
- HSIEH S W ET AL: "CHARACTERISTICS OF LOW-TEMPERATURE AND LOW-ENERGY PLASMA-ENHANCED CHEMICAL VAPOR DEPOSITED SIO2" JOURNAL OF APPLIED PHYSICS, AMERICAN INSTITUTE OF PHYSICS. NEW YORK, US, vol. 74, no. 4, 15 August 1993 (1993-08-15), pages 2638-2648, XP000393948 ISSN: 0021-8979
- TAKAMATSU A ET AL: "PLASMA-ACTIVATED DEPOSITON AND PROPERTIES OF PHOSPHOSILICATE GLASS FILM" JOURNAL OF THE ELECTROCHEMICAL SOCIETY, ELECTROCHEMICAL SOCIETY. MANCHESTER, NEW HAMPSHIRE, US, vol. 131, no. 8, August 1984 (1984-08), pages 1865-1870, XP000839945 ISSN: 0013-4651
- STRATER K: "CONTROLLED OXIDATION OF SILANE" , RCA REVIEW, RCA CORP. PRINCETON, US, VOL. 29, PAGE(S) 618-629 XP002042377 * abstract *
- LEI Q ET AL.: "Formation of optical slab waveguides using thermal oxidation of SiOx" ELECTRONICS LETTERS, vol. 29, no. 8, 15 April 1993 (1993-04-15), pages 714-716, XP002196298

## Description

### FIELD OF THE INVENTION

The present invention relates to the deposition of films onto a substrate, and in particular to the deposition of optical quality films for use in optical fiber communications, and more particularly to a method of manufacturing high quality silica films for use in waveguides and the like, for example in the manufacture of optical multiplexers and demultiplexers.

### BACKGROUND OF THE INVENTION

In the manufacture of optical devices, a common requirement is the fabrication of high quality silica films. For example, the manufacture of optical Multiplexers (Mux) and Demultiplexers (Dmux) using silica waveguides requires the deposition onto a silicon wafer of extremely transparent optical quality silica films in the 1.30 bi-directional narrow optical band and/or in the 1.55 µm video signal optical band, which the International Telecommunications Union (ITU) recommends for a Wavelength Division Multiplexing (WDM) transport network and for optical access networks for Fiber-To-The-Home (FTTH):

The following articles describe prior art techniques for depositing silica films: Hoffmann M., Low temperature, nitrogen doped waveguides on silicon with small core dimensions fabricated by PECVD/RIE, ECIO'95, 299, 1995; Bazylenko M., Pure and fluorine-doped silica films deposited in a hollow cathode reactor for integrated optic applications, J. Vac. Sci. Technol. A 14 (2), 336, 1996; Uchida N., Passively aligned hibrid WDM module integrated with spot-size converter integrated laser diode for fibre-to-the-home. Electronic Letters, 32 (18), 1996; Inoue Y., Silica-based planar lightwave circuits for WDM systems, IEICE Trans. Electron., E80C (5), 1997; Inoue Y., PLC hybrid integrated WDM transceiver module for access networks, NTT Review, 9 (6), 1997; Hoffmann M., Low-loss fiber-matched low-temperature PECVD waveguides with small-core dimensions for optical communication systems, IEEE Photonics Tech. Lett., 9 (9),1238,1997; Takahashi H., Arrayed-waveguide grating wavelength multiplexers for WDM systems, NTT Review, 10 (1), 1998; and Himeno A., Silica-based planar lightwave circuits, IEEE J. of Selected Topics in Quantum Electronics, 4 (6), 1998.

The as-deposited silica films made by these prior art techniques are never of optical quality because some absorption peaks occur in the 1.30 to 1.55 µm wavelength optical bands. High temperature thermal treatment of the silica films in a dry (nitrogen) ambient is used as in an attempt to reduce the optical absorption of silica films in the 1.30 to 1.55 µm optical region and allow the fabrication of high performance optical quality silica films and optical Multiplexers (Mux) and Demultiplexers (Dmux) with improved performances in the 1.30 bi-directional narrow optical band and/or in the 1.55 µm video signal optical band. High temperature thermal treatment of silica films in a dry (nitrogen) ambient is not, however, a very efficient way to eliminate the various absorption peaks which cause excessive optical absorption in the 1.30 to 1.55 µm optical bands.

Recently published literature indicates that various technical approaches have been tried to obtain high performance optically transparent silicate films.

A first approach is Flame Hydrolysis Deposition (FHD). This technique involves the fusion in hydrogen, oxygen and other gases of fine glass particles followed by some post-deposition anneals to 1200-1350°C. The following articles describe this approach: Suzuki S., Polarization insensitive arrayed-waveguide gratings using dopant-rich silica-based glass with thermal coefficient adjusted to silicon substrate, Electron. Lett. 33 (13), 1173, 1997; Takahashi H., Polarization-insensitive arrayed waveguide wavelenght multiplexer with birefringence compensating film, IEEE Photon. Tech. Lett. 5 (6), 707, 1993; and Kawachi M., Silica waveguides on silicon and their application to integrated-optic components, Optical and quantum Electronics, 22, 391, 1990

A second approach is the High Pressure Steam (HPS) technique. This technique involves the direct growth of silicate films from silicon under an oxygen containing ambient at very high temperature followed by a very high temperature anneal at about 1000°C. This approach is described in: Verbeek B., Integrated four-channel Mach-Zehnder multi-demultiplexer fabricated with phosphorus doped SiO2 waveguides on Si, J. Lightwave tech., 6 (6), 1011, 1988; Henry C., Four-channel wavelength division multiplexers and bandpass filters on elliptical Bragg reflectors, J. Lightwave tech., 8 (5), 748, 1990; and Adar R., Less than 1 dB per meter propagation loss of silica waveguides measured using a ring oscillator, J. Lightwave tech., 12 (8), 1369, 1994.

A third approach is the Electron-Beam Vapor Deposition (EBVD) technique of quartz or silica at about 350 °C followed by very high temperature anneals at 1200°C. See, for example, Imoto K., Silica Glass waveguide structure and its implication to a multi/demultiplexer, ECOC, 577, 1988; and Imoto K, High-silica guided-wave optical devices, 41^{st} ECTC, 483,1991

A fourth approach is to use Plasma Enhanced Chemical Vapour Deposition (PECVD) to achieve optical quality silica waveguides with reduced optical absorption of in the 1.30 to 1.55 µm optical region. See, for example, Lam D. K. W., Low temperature plasma chemical vapor deposition of silicon oxynitride thin-film waveguides, Applied Optics, 23 (16), 2744, 1984; Valette S., New integrated optical multiplexer-demultiplexer realized on silicon substrate, ECIO '87, 145, 1987; Grand G., Low-loss PECVD silica channel waveguides for optical communications, Electron. Lett., 26 (25), 2135,1990; Bruno F., Plasma-enhanced chemical vapor deposition of low-loss SiON optical waveguides at 1.5-µm wavelength, Applied Optics, 30 (31), 4560,1991; Kasper K., Rapid deposition of high-quality silicon-oxynitride waveguides, IEEE Trans. Photonics Tech. Lett., 3 (12), 1096, 1991; Lai Q., Simple technologies for fabrication of low-loss silica waveguides, Elec. Lett., 28 (11), 1000, 1992; Bulat E.S., Fabrication of waveguides using low-temperature plasma processing techniques, J. Vac. Sci. Technol. A 11 (4), 1268, 1993; Imoto K., High refractive index difference and low loss optical waveguide fabricated by low temperature processes, Electron. Lett., 29 (12), 1123, 1993; Bazylenko M. V., Fabrication of low-temperature PECVD channel waveguides with significantly imrpoved loss in the 1.50-1.55 µm wavelength range, IEEE Ptotonics Tech. Lett-, 7 (7), 774,1995; Liu K., Hybrid optoelectronic digitally tunable receiver, SPIE, Vol 2402, 104, 1995; Yokohama S., Optical waveguide on silicon chips, J. Vac. Sci. Technol. A, 13 (3), 629, 1995; Hoffmann M., Low temperature, nitrogen doped waveguides on silicon with small core dimensions fabricated by PECVD/RIE, ECIO'95, 299, 1995; Bazylenko M. V., Pure and fluorine-doped silica films deposited in a hollow cathode reactor for integrated optic applications, J. Vac. Sci. Technol. A 14 (2), 336,1996; Durandet A., Silica burried channel waveguides fabricated at low temperature using PECVD, Electronics Letters, 32 (4), 326, 1996; Poenar D., Optical properties of thin film silicon-compatible materials, Appl. Opt. 36 (21), 5122, 1997; Agnihotri O. P., Silicon oxynitride waveguides for optoelectronic integrated circuits, Jpn. J. Appl. Phys., 36, 6711, 1997; Boswell R. W., Deposition of silicon dioxide films using the helicon diffusion reactor for integrated optics applications, Plasma processing of semiconductors, Klumer Academic Publishers, 433,1997; Hoffmann M., Low-loss fiber-matched low-temperature PECVD waveguides with small-core dimensions for optical communication systems, IEEE Photonics Tech. Lett., 9 (9), 1238, 1997; Pereyra I., High quality low temperature DPECVD silicon dioxide, J. Non-Crystalline Solids, 212, 225, 1997; Kenyon T., A luminescence study of silicon-rich silica and rare-earth doped silicon-rich silica, Fourth Int. Symp. Quantum Confinement Electrochemical Society, 97-11, 304, 1997; Alayo M., Thick SiOxNy and SiO2 films obtained by PECVD technique at low temperatures, Thin Solid Films, 332, 40, 1998; Bulla D., Deposition of thick TEOS PECVD silicon oxide layers for integrated optical waveguide applications, Thin Solid Films, 334, 60, 1998; Valette S., State of the art of integrated optics technology at LETI for achieving passive optical components, J. of Modern Optics, 35 (6), 993,1988; Ojha S., Simple method of fabricating polarization-insensitive and very low crosstalk AWG grating devices, Electron. Lett., 34 (1), 78, 1998; Johnson C., Thermal annealing of waveguides formed by ion implantation of silica-on-Si, Nuclear Instruments and Methods in Physics Research, B141, 670, 1998; Ridder R, Silicon oxynitride planar waveguiding structures for application in optical communication, IEEE J. of Sel. Top. In Quantum Electron-, 4 (6), 930, 1998; Germann R., Silicon-oxynitride layers for optical waveguide applications, 195^{th} meeting of the Electrochemical Society, 99-1, May 1999, Abstract 137, 1999; Worhoff K., Plasma enhanced cyhemical vapor deposition silicon oxynitride optimized for application in integrated optics, Sensors and Actuators, 74, 9, 1999; and Offrein B., Wavelength tunable optical add-after-drop filter with flat passband for WDM networks, IEEE Photonics Tech. Lett., 11 (2), 239, 1999.

A comparison of these PECVD references is shown in Table 1, which summarises the various PECVD approaches and the reported method used to control the refractive index and to reduce the optical absorption of silica films. The various PECVD approaches can be grouped into the following categories: Unknown. PECVD reactions to reduce the optical absorption and involving B and/or P to adjust the refractive index of the silica films; PECVD using TEOS but with no details on the technique used to reduce the optical absorption and adjust the refractive index of the silica films; PECVD using oxidation of SiH₄ using O₂ but no details on the technique used to simultaneously reduce the optical absorption and adjust the refractive index of the silica films; PECVD using oxidation of SiH₄ using O₂ and CF₄ with SiH₄/O₂ flow ratio to reduce the optical absorption and SiH₄/O₂/CF₄ flow ratio to adjust the refractive index of the silica films; PECVD using oxidation of SiH₄ using N₂O with SiH₄/N₂O flow ratio to simultaneously reduce the optical absorption and adjust the refractive index of the silica films; PECVD using oxidation of SiH₄ using N₂O and N₂ with SiH₄/N₂O/N₂ flow ratio to reduce the optical absorption and to adjust the refractive index of the silica films; PECVD using oxidation of SiH₄ using N₂O and Ar with SiH₄/N₂O/Ar flow ratio to reduce the optical absorption and to adjust the refractive index of the silica films; and PECVD using oxidation of SiH₄ using N₂O and NH₃ with SiH₄/N₂O flow ratio to reduce the optical absorption and SiH₄/N₂O/NH₃ flow to adjust the refractive index of the silica films.

**Table 1**

| Publication | PECVD Reaction | Deposition |
|---|---|---|
| | | Control Method |
| Valette S.,1987 | Unknown | Content in Si, P |
| Valette S.,1988 | Unknown | Content in Si, P |
| Grand G., 1990 | Unknown | Content in Si, P |
| Liu K, 1995 | Unknown | Content in Si, P |
| Ojha S., 1998 | Unknown | Content in Si, B, P |
| Bulla D., 1998 | TEOS | TEOS |
| Johnson C, 1998 | SiH₄ + O₂ | Unknown |
| Bazylenko M. V., 1995 | SiH₄ + O₂ + CF₄ | SiH₄/O₂/CF₄ flow ratio |
| Bazylenko M. V., 1995 | SiH₄ + O₂ + CF₄ | SiH₄/O₂/CF₄ flow ratio |
| Bazylenko M. V., 1996 | SiH₄ + O₂ + CF₄ | SiH₄/O₂/CF₄ flow ratio |
| Durandet A., 1996 | SiH₄ + O₂ + CF₄ | SiH₄/O₂/CF₄ flow ratio |
| Boswell R W.,1997 | SH₄ + O₂ + CF₄ | SiH₄/O₂/CF₄ flow ratio |
| Kasper K., 1991 | SiH₄ + N₂O | SiH₄/N₂O flow ratio |
| Lai Q., 1992 | SiH₄+N₂O | SiH₄/N₂O flow ratio |
| Pereyra L, 1997 | SiH, + N₂O | SiH₄/N₂O flow ratio |
| Alayo M., 1998 | SiH₄ + N₂O | SiH₄/N₂O flow ratio |
| Imoto K., 1993 | SiH₄ + N₂O + N₂ | SiH₄/N₂O/N₂ flow ratio |
| This Patent | SiH₄+ N₂O + N₂ | Patented Method |
| Kenyon T.,1997 | SiH₄ + N₂O + Ar | SiH₄/N₂O/Ar flow ratio |
| Lam D. K. W.,1984 | SiH₄ + N₂O + NH₃ | SiH₄/N₂O/NH₃ flow ratio |
| Bruno F., 1991 | SiH₄ + N₂O + NH₃ | SiH₄/N₂O/NH₃ flow ratio |
| Yokohama S., 1995 | SiH₄ + N₂O + NH₃ | SiH₄/N₂O/NH₃ flow ratio |
| Agnihotri O. P., 1997 | SiH₄ + N₂O + NH₃ | SiH₄/N₂O/NH₃ flow ratio |
| Gerinann R., 1999 | SiH₄ + N₂O + NH₃ | Unknown |
| Offrein B-, 1999 | SiH₄ + N₂O + NH₃ | Unknown |
| Hoffmann M., 1995 | SiH₄ + N₂O + NH₃+ Ar | SiH₄/N₂O/NH₃/Ar flow ratio |
| Hoffmann M., 1997 | SiH₄ + N₂O + NH₃+ Ar | SiH₄/N₂O/NH₃/Ar flow ratio |
| Poenar D., 1997 | SiH₄+ N₂O + NH₃+ N₂ | SiH₄/N₂O/NH₃/N₂ flow ratio |
| Ridder R, 1998 | SiH₄ + N₂O + NH₃+ N₂ | SiH₄/N₂O/NH₃/Ar flow ratio |
| Worhoff K, 1999 | SiH₄ + N₂O + NH₃+ N₂ | SiH₄/N₂O/NH₃/N₂ flow ratio |
| Bulat ES., 1993 | SiH₄ + N₂O + N₂+ CF₄ | SiH₄/N₂O/N₂/CF₄ flow ratio |

FITR spectra of optical quality silica films are characterized by the presence of only four optical absorption peaks. Generally the objective in producing optical quality films is to produce FITR spectra only showing the four infrared absorption peaks of optical quality silica films. These peaks consists of an intense and small Full Width at Half Maximum (FWHM) Si-O-Si "rocking mode" absorption peak ranging between 410 and 510 cm⁻¹, centred at 460 cm⁻¹ (21.739 µm); a small FWHM Si-O-Si "bending mode" absorption peak ranging between 740 and 880 cm⁻¹, centred at 810 cm⁻¹ (12.346 µm); a very intense and small Full Width at Half Maximum (FWHM) Si-O-Si "in-phase-stretching mode" absorption peak ranging between 1000 and 1160 cm⁻¹, centred at 1080 cm⁻¹ (9.256 µm) indicating stoichiometric silica films with the optimum Si-O-Si bond angle of 144° and the optimum density; and an Si-O-Si "out-of-phase-stretching mode" absorption peak ranging between 1080 and 1280 cm⁻¹, centred at 1180 cm⁻¹ (8.475 µm), as compared to the Si-O-Si in-phase-stretching mode absorption peak. This latter peak should be almost eliminated.

The position in the infrared spectra of these four fundamental mode absorption peaks, respectively centered at 21.739 µm, 12.346 µm, 9.256 µm and 8.475 µm, is far away from the infrared band of interest which ranges from 1.30 to 1-55 um.

Residual absorption of optical quality silica is never completely eliminated because the higher harmonics of these four fundamental residual absorption peaks do cause small residual optical absorption peaks in the 130 to 155 µm optical band. This residual absorption of optical quality silica is so small that many km of silica optical fiber can be used with negligible absorption in this optical band. This is explained by the fact that only the very high harmonics of these four residual absorption peaks do fall in the 1.30 to 1.55 µm optical band, namely the sixth (1.302 to 1.543 µm) and seventh (1.116 to 1.323 µm) harmonics of the Si-O-Si "out-of-phase-stretching mode" infrared absorption peak; the sixth (1.437 to 1.667 µm) and seventh (1.232 to 1.429 µm) harmonics of the Si-O-Si "in-phase-stretching mode" infrared absorption peak; the eighth (1.420 to 1.689 µm) and ninth (1.263 to 1.502 µm) harmonics of the Si-O-Si "bending mode" infrared absorption peak; and the thirteenth (1.508 to 1.876 µm), fourteenth (1.401 to 1.742 µm) and fifteenth (1.307 to 1.626 µm) harmonics of the Si-O-Si "rocking mode" infrared absorption peak.

The FTIR spectra of optical quality silica films are also characterized by a net separation between the Si-O-Si "in-phase-stretching mode" absorption peak (1080 cm⁻¹) and the Si-O-Si "bending mode" absorption peak (810 cm⁻¹) with a deep valley between 850 and 1000 cm⁻¹.

Such optical quality silica films are extremely difficult to produce because residual hydrogen and nitrogen atoms are typically present in the films. In reality FTIR spectra also show other infrared absorption peaks having higher harmonics in the 1.30 to 1-55 µm optical bands. As mentioned before, various PECVD approaches can be used to control the refractive index and to reduce the optical absorption of the deposited silica films. The expected result is an optical quality silica with the expected infrared transmission spectra. Fourier Transformed Infrared Reflectance, FTIR, spectroscopy can monitor the quality of the obtained silica films.

The High temperature thermal treatments also have their own shortcomings. Optical quality silica films typically require a post-deposition thermal treatment at a high temperature as high as 1350°C in order to eliminate residual optical absorption peaks in the 1.30 to 155 µm optical region.

EP 0 624 660 discloses a method of forming BPSG film in a PECVD reactor wherein the total system pressure is in the range of 327 - 347 Pa. This patent does not disclose an optimization technique.

Wu T H T et al: "Stress in PSG and Nitride Films as related to Film Properties and Annealing", Solid State Technology, Cowan Publ. Corp. Washington, US vol. 35, no 5, 1 May 1992 (pages 65 - 72)" summarizes the Novellus Concept 1 PECVD tool process for the deposition of phosphosilicate glass with SiH₄ as the silicon source, N₂O as the oxidizer, and N₂ as the carrier gas. The standard pressure for the chemistry of this tool is 293 Pa (2.2 torr). The influence of post-deposition annealing on the elimination of impurities, such as Si-H, Si-OH, N-H bonds is discussed.

Hsieh S W et al: "Characteristics of Low-Temperature and Low-Energy Plasma Enhanced Chemical Vapoor Deposited SiO2", Journal of Applied Physics, New York, US vol. 74, no. 4,15 August 1993, pages 2638-2648 discloses a PECVD process for SiO₂ or PSG using SiH₄ as the silicon source, N₂O as the oxidizer, and N₂ as the carrier gas with an upper pressure of 267Pa (2 torr).

An object of the invention is to provide an improved technique for producing optical quality silica films.

### SUMMARY OF THE INVENTION

The invention provides a technique for depositing silica films that uses Plasma Enhanced Chemical Vapour Deposition, but which results in a better elimination of undesirable residual Si:N-H oscillators (observed as a FTIR peak centered at 3380 cm⁻¹) after thermal treatment at lower post-deposition temperature to provide improved optical quality silica waveguides with reduced optical absorption of in the 1.30 to 1.55 µm optical region. Such waveguides are suitable for use in the fabrication of high performance optical quality Multiplexers (Mux) and Demultiplexers (Dmux) with improved performances in the 1.30 bi-directional narrow optical band and/or in the 1.55 µm video signal optical band.

The fabrication of improved PECVD optical quality silica films can be achieved using a commercially available PECVD system, for example, the "Concept One" system manufactured by Novellus Systems in California, USA. The optical quality silica films in accordance with the invention are obtained using a lower temperature post-deposition thermal treatment due to an improved PECVD deposition technique. The present invention permits the deposition of improved silica films that result in a better elimination of the undesirable residual Si:N-H oscillators (observed as a FTIR peak centered at 3380 cm⁻¹) after thermal treatments at lower post-deposition temperature to provide improved optical quality silica waveguides with reduced optical absorption of in the 1.30 to 1.55 µm optical region in order to use them in the fabrication of high performance optical quality Multiplexers (Mux) and

Demultiplexers (Dmux) with improved performances in the 1.30 bi-directional narrow optical band and/or in the 1.55 µm video signal optical band. According to the present invention, there is provided a method of depositing an optical quality silica film on a substrate, wherein said optical quality silica film is deposited on said substrate by plasma enhanced chemical vapor deposition (PECVD) at a temperature between 100 and 650°C in the presence of SiH₄, N₂O and N₂ gases, characterized in that:
a) the flow rates of said SiH₄, N₂O and N₂ gases are controlled at predetermined fixed values;
b) silica films are deposited on said substrate at different total deposition pressures varying between 267 - 347 Pa (2.0 and 2.6 Torr);
c) the optical absorption and/or refractive index of the deposited silica films are observed to determine the optimum total deposition pressure;
d) the optical quality silica film is deposited while controlling said total deposition pressure to said optimum total deposition pressure determined in step c; and
e) the deposited optical quality silica film is subjected to a low temperature treatment between 400° and 1200°C to minimize the presence of contaminant compounds in said film.

Preferably, the low temperature treatment is at 800°C. Preferably, the total gas pressure is 320 Pa (2.4 Torr).

The film is deposited at a temperature between 100 and 650°C, and preferably at a temperature of 400°C.

Optimally, the flow rate of the SiH₄ is 0.2 std liter/min., the flow rate of the N₂O is 6.00 std liter/min., and the flow rate of the N₂ is 3.15 std liter/min.

The novel PECVD approach in accordance with the invention can provide undoped (no B and/or P) silica films from the oxidation of silane, SiH₄, using nitrous oxide, N₂O.

### BRIEF DESCRIPTION OF THE DRAWINGS

The invention will now be described in more detail, by way of example only, with reference to the accompanying drawings, in which:-
Figure 1 is a table showing the various Si-Oₓ-H_{y}-Nₓ as-deposited compounds that may result from the combinations of a silane (SiH4) and nitrous oxide (N2O) gas mixture;
Figure 2 is a table showing the chemical reactions of the thirty-five (35) as-deposited compounds that could be found in silica films deposited from a silane (SiH₄) and nitrous oxide (N₂O) gas mixture;
Figure 3 is a table listing the possible chemical reactions that may result from the exposure of the thirty-five (35) as-deposited compounds to nitrogen at very high temperature;
Figure 4 shows the FTIR fundamental infrared absorption peaks and their corresponding higher harmonics peaks associated with the six (6) residual potential post-treatment compounds that result from a high temperature thermal treatment of silica films in a nitrogen ambient;
Figure 5a shows the basic FTIR spectra of PECVD silica films before and after a three hours long high temperature thermal treatment in a nitrogen ambient at a temperature of either 600, 700, 800, 900, 1000 or 1100°C;
Figure 5b shows the basic FTIR spectra of silicon films obtained with the improved PECVD deposition technique after a three hours long high temperature thermal treatment in a nitrogen ambient at a low temperature of 800°C;
Figure 6a shows the in-depth FTIR spectra from 810 to 1000 cm⁻¹ of PECVD silica films before and after a three hours long high temperature thermal treatment in a nitrogen ambient at a temperature of either 600, 700, 800, 900, 1000 or 1100°C;
Figure 6b shows the in-depth FTIR spectra from 810 to 1000 cm⁻¹ of silica films obtained with the improved deposition technique after a three hour long high temperature thermal treatment in a nitrogen ambient at a low temperature of 800°C;
Figure 7a shows the in-depth FTIR spectra from 1500 to 1600 cm⁻¹ of PECVD silica films before and after a three hours long high temperature thermal treatment in a nitrogen ambient at a temperature of either 600, 700, 800, 900, 1000 or 1100°C;
Figure 7b shows the in-depth FTIR spectra from 1500 to 1600 cm⁻¹ of silica films obtained with the improved PECVD deposition technique after a three hours long high temperature thermal treatment in a nitrogen ambient at a low temperature of 800°C;
Figure 8a shows the in-depth FTIR spectra from 1700 to 2200 cm⁻¹ of PECVD silica films before and after a three hours long high temperature thermal treatment in a nitrogen;
Figure 8b shows the in-depth FTIR spectra from 1700 to 2200 cm⁻¹ of silica films obtained with the improved PECVD deposition technique after a three hours long high temperature;
   thermal treatment in a nitrogen ambient at a low temperature of 800°C;
Figure 9a shows the in-depth FTIR spectra from 2200 to 2400 cm⁻¹ of PECVD silica films before and after a three hours long high temperature thermal treatment in a nitrogen;
Figure 9b shows the in-depth FTIR spectra from 2200 to 2400 cm⁻¹ of silica films obtained with the improved PECVD deposition technique after a three hours long high temperature thermal treatment in a nitrogen ambient at a low temperature of 800°C;
Figure 10a shows the in-depth FTIR spectra from 3200 to 3900 cm⁻¹ of PECVD silica films before and after a three hours long high temperature thermal treatment in a nitrogen;
Figure 10b shows the in-depth FTIR spectra from 3200 to 3900 cm⁻¹ of silica films obtained with the improved PECVD deposition technique after a three hours long high temperature thermal treatment in a nitrogen ambient at a low temperature of 800°C;
Figure 11 shows the effect of the total deposition pressure on the integrated area under the 3380 cm-¹ FTIR peak of the Si:N-H oscillators of PECVD silica films deposited at a fixed SiH₄ gas flow of 0.20 std liter/min, at a fixed N₂O gas flow of 6.00 std liter/min, at a fixed N₂ gas flow of 3.15 std liter/min and following a thermal treatment in a nitrogen ambient at 800°C;
Figure 12 shows the effect of the total deposition pressure on the 1.55 µm refractive index of PECVD silica films deposited at a fixed SiH₄ gas flow of 0.20 std liter/min, at a fixed N₂O gas flow of 6.00 std liter/min, at a fixed N₂ gas flow of 3.15 std liter/min and following a thermal treatment in a nitrogen ambient at 800°C;
Figure 13 shows the effect of the N2O gas flow on the 1.55 µm refractive index of PECVD silica films deposited at a fixed SiH4 gas flow of 0.20 std liter/min, at a fixed N2 gas flow of 3.15 std liter/min, at a fixed total deposition pressure of is 347 Pa (2.60 Torr) and following a thermal treatment in a nitrogen ambient at 800°C; and
Figure 14 shows the effect of the N₂O gas flow on the 1.55 µm refractive index of PECVD silica films deposited at a fixed SiH₄ gas flow of 0.20 std liter/min, at a fixed N₂ gas flow of 3.15 std liter/min, at a fixed total deposition pressure of is 347 Pa (2.60 Torr) and following a thermal treatment in a nitrogen ambient at 800°C.

### DETAILED DESCRIPTON OF THE PREFERRED EMBODIMENTS

The deposition of silica films by PECVD from a silane, SiH₄, and nitrous oxide, N₂O, gas mixture at a relatively low temperature of 400°C is typically described by the following reaction:

SiH₄(g) + 2N₂O(g) → SiO₂ + 2N₂(g) + 2H₂(g)

This chemical reaction shows that it should theoretically be possible to achieve optical quality silica films directly from silane and nitrous oxide. This would be true if this was really the only chemical reaction involved in the deposition of the silica films.

In reality the incorporation of oxygen atoms, a key factor to achieve optical quality silica, competes with the incorporation of nitrogen and hydrogen atoms in the silica films. At a microscopic scale, the local incorporation of nitrogen and hydrogen atoms results in a mixture of a considerable number of undesirable Si-Oₓ-H_{y}-N_{z} as-deposited compounds that are bonded to each other as to form the deposited silica films.

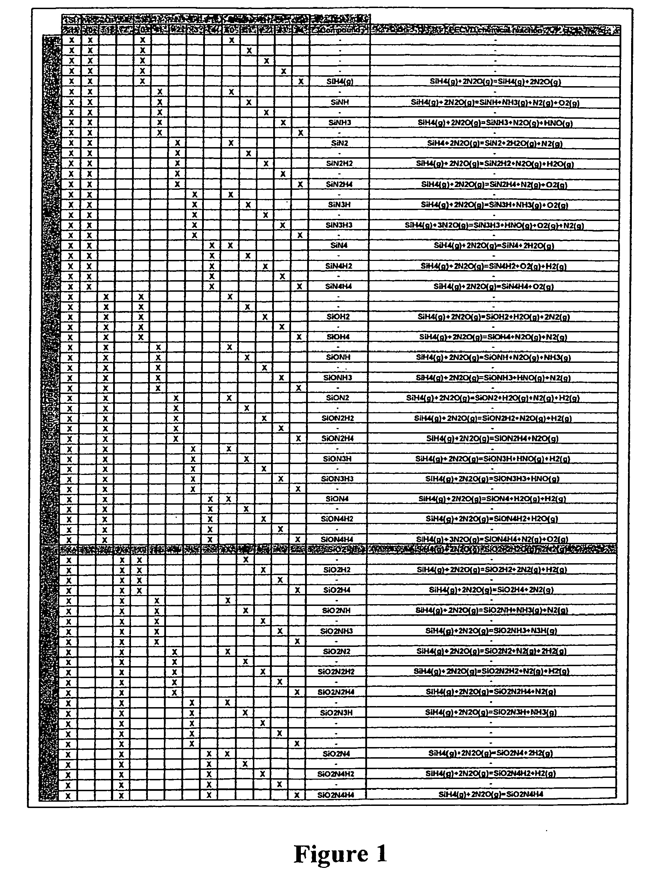

Figure 1 lists the various Si-Oₓ-H_{y}-N_{z} possible as-deposited compounds that may result from the combinations of a silane (SiH₄) and nitrous oxide (N₂O) gas mixture. It shows seventy-five (75) combinations of potential as-deposited compounds: 0 to 2 oxygen atoms (3 combinations); 0 to 4 nitrogen atoms (5 combinations); and 0 to 4 hydrogen atoms.(5 combinations).

Only thirty-five (35) of these seventy-five (75) combinations can actually form potential as-deposited compounds that can accommodate the chemical bonds of their constituting atoms: 4 chemical bonds for silicon; 2 chemical bonds for oxygen; 3 chemical bonds for nitrogen; and 1 hydrogen bond for hydrogen.

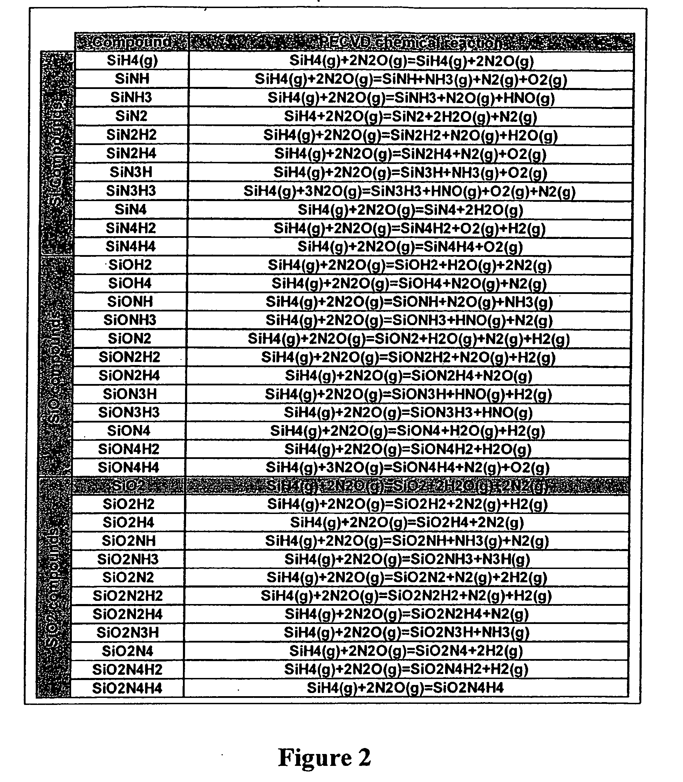

Figure 2 lists the chemical reactions of the thirty-five (35) potential as-deposited compounds that could form in silica films deposited from a silane (SiH₄) and nitrous oxide (N₂O) gas mixture. During these chemical reactions, it is clear that N₂, O₂ HNO, NH₃, H₂O, and H₂ gaseous compounds must be eliminated from the micro-pores of the growing silica films up to their surface and from their surface through the gaseous boundary layer present near their surface. It is also dear that many of these chemical reactions involve a modification of the number of gaseous compounds; i.e. that the number of gaseous product compound molecules is different than three, the number of gaseous reactant compound molecules. Then, the fundamentals of classical thermodynamics predict that the equilibrium constants of these many chemical reactions will be affected by the total deposition pressure and that the optimization of the silica films requires more then just controlling the ratio of silane-to-nitrous oxide gas flow ratios.

The obtained silica films are the result of these competing chemical reactions and are composed of a mixture of these various Si-Oₓ-H_{y}-N_{z} potential as-deposited compounds. To these potential as-deposited compounds are associated interatomic oscillators which can be detected by FTIR as absorption peaks which are different from the four characteristic peaks of ideal optical silica films. Some of these extra absorption peaks do have a higher harmonics mode that cause optical absorption in the 1.30 to 1:55 µm optical bands. For that reason, the prior art uses a post-deposition high temperature thermal treatment of silica films in a dry (nitrogen) ambient at a temperature ranging between 600 and 1350°C in an attempt eliminate these extra absorption peaks in the 1.30 to 1.55 µm optical region.

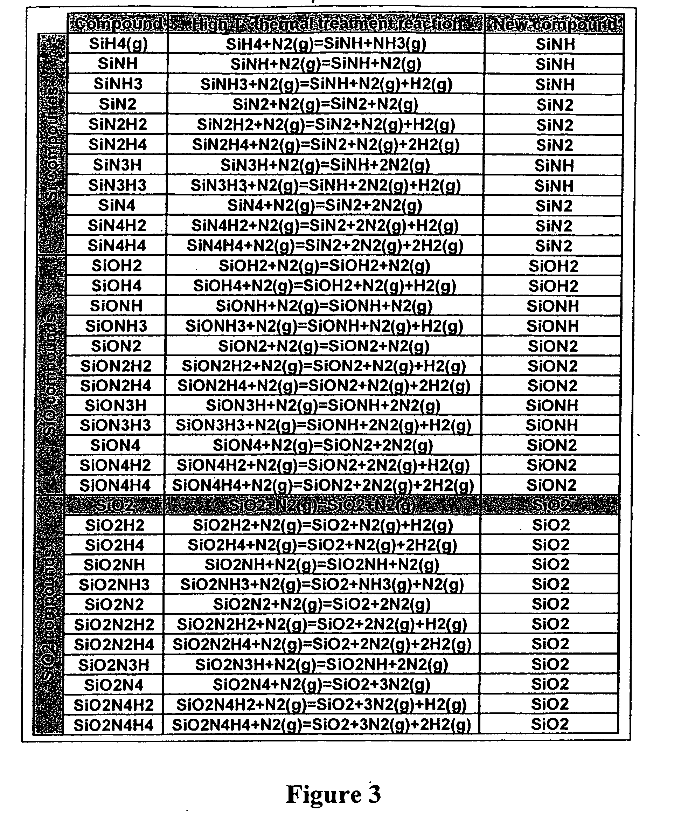

Figure 3 lists the possible chemical reactions (i.e. thermal decomposition reactions) that may result from the exposure of the thirty-five (35) potential as-deposited compounds to nitrogen at very high temperature. Again, the thermal decomposition reactions (producing a potential post-treatment compound after the high temperature thermal treatment which is different then the potential as-deposited compound before high temperature thermal treatment) have to preserve the need to accommodate the chemical bonds of their constituting atoms. These various reactions present a very clear overview of the limitations of these high temperature thermal treatments:

Only twelve (12) of the thirty-five (35) Si-Oₓ-H_{y}-N_{z} potential as-deposited compounds can lead to the formation of SiO₂ during a high temperature thermal treatment in a nitrogen ambient with gaseous by-products such as: nitrogen, N₂, hydrogen, H₂, and ammonia, NH₃.

Following a high temperature thermal treatment in a nitrogen ambient, the other twenty-three (23) Si-Oₓ-H_{y}-N_{z} potential as-deposited compounds can lead to the formation of a short list of five (5) other potential post-treatment compounds: SiNH (no O incorporated in the potential as-deposited compound); SiN₂ (no O incorporated in the potential as-deposited compound); SiOH₂ (one O incorporated in the potential as-deposited compound); SiONH (one O incorporated in the potential as-deposited compound); and SiON₂ (one O incorporated in the potential as-deposited compound).

It is important to realize that high temperature thermal treatment in a nitrogen ambient produces thermal decomposition reactions which are incapable of transforming the twenty-three (23) potential Si-Oₓ-H_{y}-N_{z} as-deposited compounds that result, from a lack of oxygen incorporation into SiO₂, in the other five potential post-treatment compounds. It is then also very important to realize that the displacement of the equilibrium constants of these many chemical reactions which result in the formation of these twenty-three (23) oxygen-lacking potential Si-Ox-Hy-Nz as-deposited compounds as a result of a modification of the total deposition pressure will have a definitive effect on the optimization of the silica films and that this effect will allow the deposition of silica films with optical properties not achievable with a more traditional adjustment of the silane-to-nitrous oxide gas flow ratios.

As a result a control of the total deposition pressure independently of the silane-to-nitrous oxide gas flow ratio can have a pronounced effect on the optical properties of silica films following a lower temperature nitrogen thermal treatment.

Since the silica films that result from these high temperature thermal treatments in a nitrogen ambient are solid mixtures of six (6) potential post-treatment - compounds: SiO₂, SiNH, SiN₂, SiOH₂, SiONH and SiON₂, the FTIR spectra can be used to verify this hypothesis by monitoring the transformation of these six (6) residual potential post-treatment compounds.

In general the higher the temperature the lower the optical absorption of the silica films but unlike the case for the fused silica optical fibres, which are heated at a temperature exceeding about 2000°C during the drawing process, the high temperature thermal treatment of the silica films on silicon wafers is performed at a much lower temperature of less then about 1350°C, the fusion point of the silicon wafer. The thermal treatment temperature is also typically limited by the high compressive mechanical stress induced in the silica films from the difference of thermal expansion between the silica films and the underlying silicon wafer.

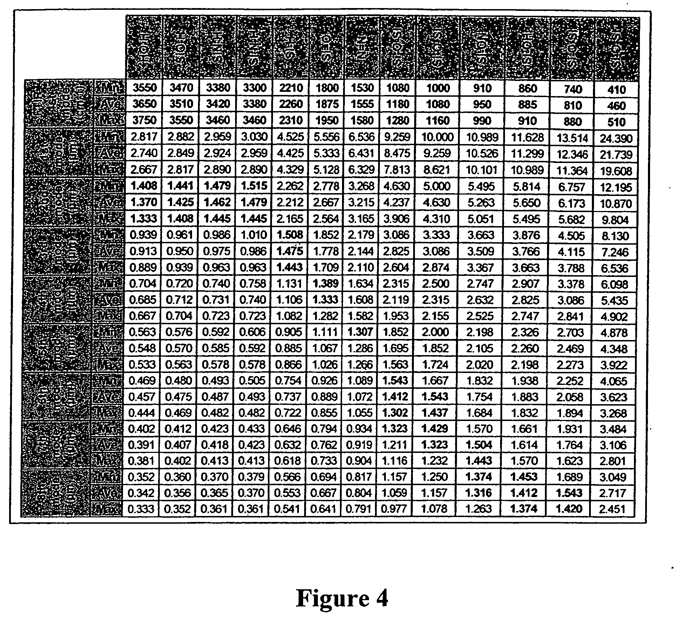

Figure 4 lists some FTIR fundamental infrared absorption peaks and their corresponding higher harmonics peaks associated with the six (6) residual potential post-treatment compounds that result from thermal decomposition during a high temperature thermal treatment of these silica films in a nitrogen ambient. It is clear from Figure 4 that the higher harmonics of the absorption peaks corresponding to these six (6) residual potential post-treatment compounds contribute to the optical absorption in the 1.30 to 1.55 µm optical bands. The six peaks are: the second vibration harmonics of the HO-H oscillators in trapped water vapour in the micro-pores of the silica films (3550 to 3750 cm⁻¹), which increase the optical absorption near 1.333 to 1.408 µm; the second vibration harmonics of the SiO-H oscillators in the silica films (3470 to 3550 cm⁻¹), which increase the optical absorption near 1.408 to 1.441 µm; the second vibration harmonics of the Si:N-H oscillators in the silica films (3300 to 3460 cm⁻¹), which increase the optical absorption near 1.445 to 1.515 µm; the second vibration harmonics of the SiN-H oscillators in the silica films (3380 to 3460 cm⁻¹), which increase the optical absorption near 1.445 to 1.479 µm; the third vibration harmonics of the Si-H oscillators in the silica films (2210 to 2310 cm⁻¹), which increase the optical absorption near 1.443 to 1.505 µm; the fourth vibration harmonics of the Si=O oscillators in the silica films (1800 to 1950 cm⁻¹), which increase the optical absorption near 1.282 to 1.389 µm; and the fifth vibration harmonics of the N=N oscillators in the silica films (1530 to 1580 cm⁻¹), which increase the optical absorption near 1.266 to 1.307 µm.

The negative effects of these the oscillators on the optical properties of silica films are reported in the literature. Examples of relevant literature articles are: Grand G., Low-loss PECVD silica channel waveguides for optical communications, Electron. Lett., 26 (25), 2135, 1990; Bruno F., Plasma-enhanced chemical vapor deposition of low-loss SiON optical waveguides at 1.5-µm wavelength, Applied Optics, 30 (31), 4560, 1991; Imoto K., High refractive index difference and low loss optical waveguide fabricated by low temperature processes, Electronic Letters, 29 (12), 1993; Hoffmann M., Low temperature, nitrogen doped waveguides on silicon with small core dimensions fabricated by PECVD/RIE, ECIO'95, 299, 1995; Bazylenko M., Pure and fluorine-doped silica films deposited in a hollow cathode reactor for integrated optic applications, J. Vac. Sci. Technol. A 14 (2), 336, 1996; Pereyra I., High quality low temperature DPECVD silicon dioxide, J. Non-Crystalline Solids, 212, 225, 1997; Kenyon A., A luminescence study of silicon-rich silica and rare-earth doped silicon-rich silica, Electrochem. Soc Proc. Vol. 97-11, 304, 1997; Alayo M., Thick SiOxNy and SiO2 films obtained by PECVD technique at low temperatures. Thin Solid Films, 332, 40, 1998; Worhoff K., Plasma enhanced chemical vapor deposition silicon oxynitride optimized for application in integrated optics, Sensors and Actuators, 74, 9, 1999; and Germann R., Silicon-oxynitride layers for optical waveguide applications, 195^{th} meeting of the Electrochemical Society, 99-1, May 1999, Abstract 137, 1999.

This literature describes the tentative elimination of optical absorption (i.e. of the six residual oscillators) using the discussed thermal decomposition reactions during thermal treatments under a nitrogen ambient at a maximum temperature lower then 1350°C, the fusion point of the silicon wafer. As mentioned, these thermal decomposition reactions in a nitrogen ambient result in a potential of six residual oscillators in the treated silica films which still absorb infrared light in the 1.30 to 1.55 µm optical region.

The lack of incorporation of oxygen atoms into the deposition reaction produces, at a microscopic scale, a mixture of the thirty-five (35) undesirable Si-Oₓ-H_{y}-N_{z} potential as-deposited compounds (listed in Figure 2) difficult to eliminate with temperature treatments.

Twenty-three (23) of these thirty-five (35) undesirable Si-Oₓ-H_{y}-N_{z} potential as-deposited compounds are sub-stoichiometric oxygen compounds (Figure 4) and this makes it very unlikely that temperature treatments in nitrogen inducing thermal decomposition of these residual as-deposited compounds will result in the required pure silicate, SiO₂, films; i.e. that the thermal decomposition in nitrogen will not likely be able to completely eliminate the five residual undesirable post-treatment compounds: SiNH, SiN₂, SiOH₂, SiONH and SiON₂ associated to the various residual undesirable oscillators which prevent the achievement of optical quality silica waveguides with reduced optical absorption of in the 1.30 to 1.55 µm optical region.

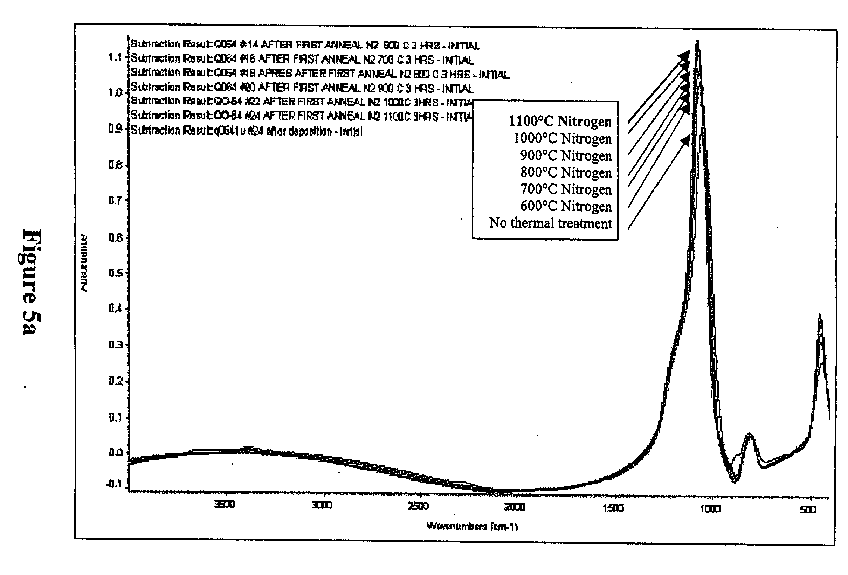

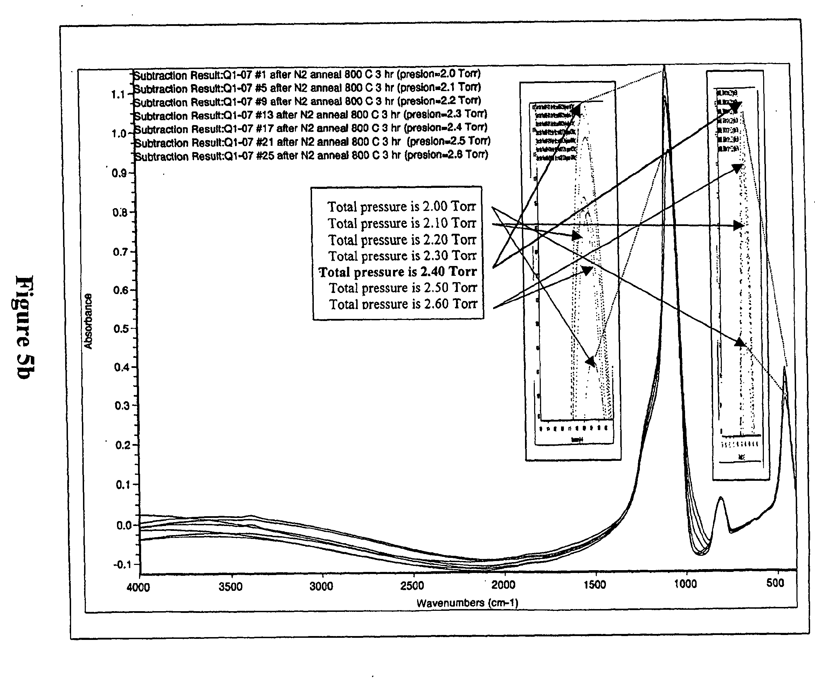

Figure 5a shows the basic FTIR spectra of typically deposited PECVD silica films before and after a three hours long high temperature thermal treatment in a nitrogen ambient at a temperature of either 600, 700, 800, 900, 1000 or 1100°C. It is dear that the higher the thermal decomposition temperature of the high temperature thermal treatment in a nitrogen ambient, the better the thermal decomposition of silica films, the better the elimination of: nitrogen, N₂, hydrogen, H₂, and ammonia, NH₃. (i.e. as per the chemical reactions of Figure 3) and the better the FTIR spectra of the treated silica films (i.e. the better the four basic optical absorption peaks):
■ A more intense and smaller FWHM Si-O-Si "rocking mode" absorption peak ranging between 410 and 510 cm⁻¹;
■ A smaller FWHM Si-O-Si "bending mode" absorption peak ranging between 740 and 880 cm⁻¹;
■ A more intense and smaller FWHM Si-O-Si "in-phase-stretching mode" absorption peak ranging between 1000 and 1160 cm⁻¹, indicating a more stoichiometric silica films with the optimum density and optimum Si-O-Si bond angle of 144°;
■ A gradual elimination of the Si-O-Si "out-of-phase-stretching mode" absorption peak ranging between 1080 and 1280 cm⁻¹, as compared to the Si-O-Si in-phase-stretching mode absorption peak;
■ A gradual separation between the Si-O-Si "in-phase-stretching mode" absorption peak (1080 cm⁻¹) and the Si-O-Si "bending mode" absorption peak (810 cm⁻¹) with a deeper valley between 850 and 1000 cm⁻¹.

An in-depth examination of some infrared regions of the FTIR spectra of Figure 5a with the help of the FTIR regions of the table of Figure 4 helps verify the presence of the six (6) residual potential post-treatment compounds: SiO₂, SiNH, SiN₂, SiOH₂, SiONH and SiON₂ that potentially contribute to the reported residual optical absorption in the 1.30 to 1.55 µm wavelength optical bands.

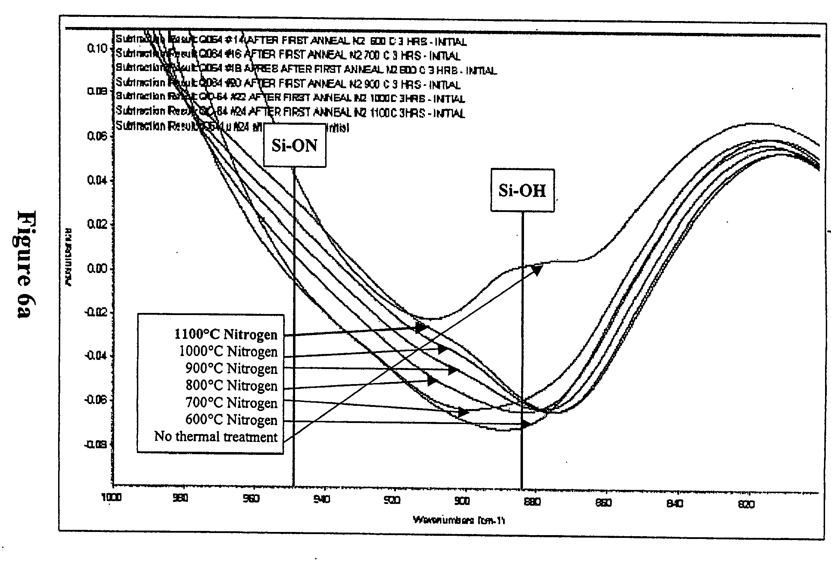

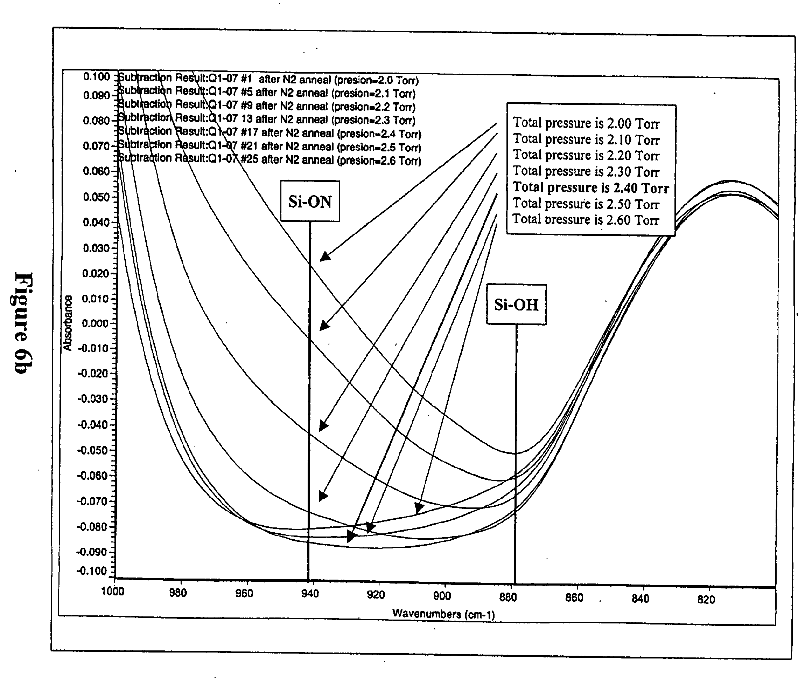

Figure 6a shows the in-depth FTIR spectra from 810 to 1000 cm⁻¹ of typically deposited PECVD silica films before and after a three hours long high temperature thermal treatment in a nitrogen ambient at a temperature of either 600, 700, 800, 900, 1000 or 1100°C. This region of the FTIR spectra should show a net separation between the Si-O-Si "in-phase-stretching mode" absorption peak (1080 cm⁻¹) and the Si-O-Si "bending mode" absorption peak (810 cm⁻¹) and should show a deep valley between 850 and 1000 cm⁻¹. It is clear that the higher the thermal decomposition temperature of the high temperature thermal treatment in a nitrogen ambient, the better the separation and the deeper the valley. The reduction and gradual elimination of the Si-OH oscillators, centered at 885 cm⁻¹ (i.e. of some configurations of the SiOH₂ residual potential post-treatment compounds) using various chemical reactions of Figure 3 is demonstrated to occur following the 600°C thermal treatment in a nitrogen ambient. A residual peak is observed at 950 cm⁻¹, indicating the presence of residual oscillators as a result of the various thermal decomposition reactions of Figure3. These residual oscillators are associated to the Si-ON oscillators of two (2) of the six (6) residual potential post-treatment compounds: SiONH and SiON₂. It is clear that the higher the temperature of the high temperature thermal treatment from 600 to 1100°C in a nitrogen ambient, the more nitrogen incorporation and the more evident the Si-ON oscillators (i.e. some configurations of the residual potential: SiONH and/or SiON₂ post-treatment compounds).

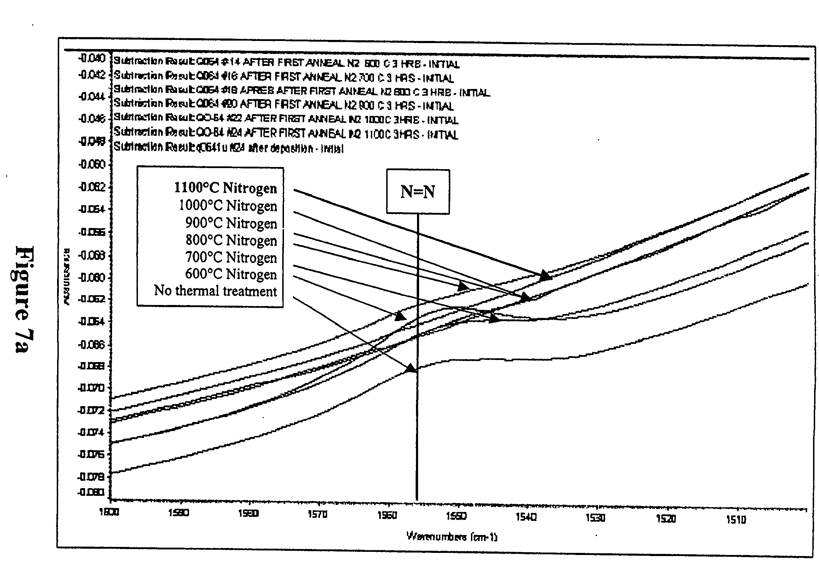

Figure 7a shows the in-depth FTIR spectra from 1500 to 1600 cm⁻¹ of typically deposited PECVD silica films before and after a three hours long high temperature thermal treatment in a nitrogen ambient at a temperature of either 600, 700, 800, 900, 1000 or 1100°C. This region of interest focuses on the N=N oscillators, centered at 1555 cm⁻¹, of the various post-treatment compounds described by the various chemical reactions of Figure 3. It is apparent that the higher the thermal decomposition temperature of the high temperature thermal treatment in a nitrogen ambient, the better the elimination of N=N oscillators (which fifth harmonics could cause an optical absorption between 1.266 and 1.307 µm) with a complete elimination of residual N=N oscillators (i.e. some configurations of the residual potential SiON₂ post-treatment compounds) after a thermal treatment beyond 900°C in a nitrogen ambient.

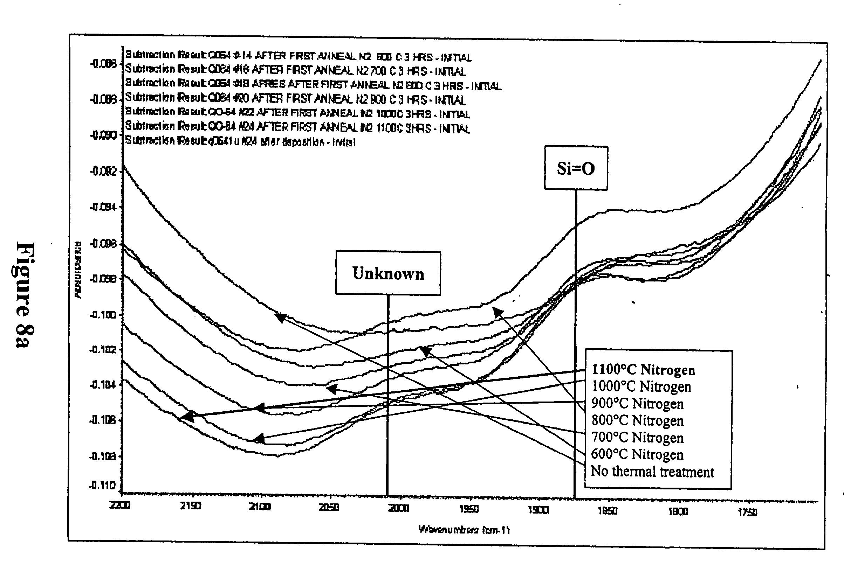

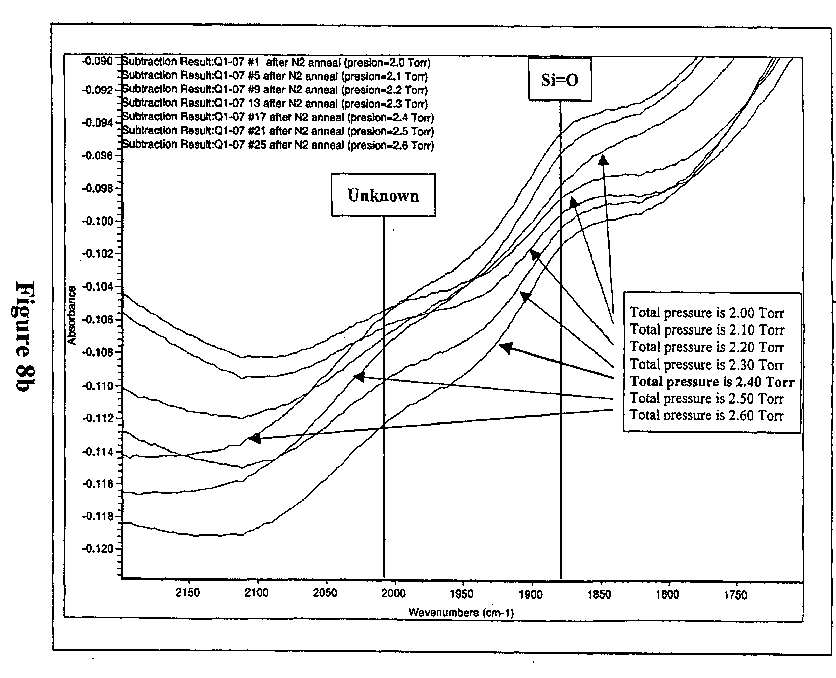

Figure 8a shows the in-depth FTIR spectra from 1700 to 2200 cm⁻¹ of typically deposited PECVD silica films before and after a three hours long high temperature thermal treatment in a nitrogen ambient at a temperature of either 600, 700, 800, 900, 1000 or 1100°C. This region of interest focuses on the Si=O oscillators, centered at 1875 cm⁻¹ of four (4) of the six (6) residual potential post-treatment compounds: SiO₂, SiOH₂, SiONH and SiON₂. Another unknown absorption peak is also observed centered at 2010 cm⁻¹ but since this unknown oscillator does not have a higher harmonics which could cause optical absorption in the 1.30 to 1.55 µm optical bands, the search of its identity was not prioritized. It is clear that the higher the thermal decomposition temperature of the high temperature thermal treatment from 600 to 1100°C in a nitrogen ambient, the more evident the Si=O oscillators (which fourth harmonics could cause an optical absorption between 1.282 and 1.389 µm) and the more evident the unknown oscillators which have no higher absorption harmonics between 1.300 and 1.550 µm.

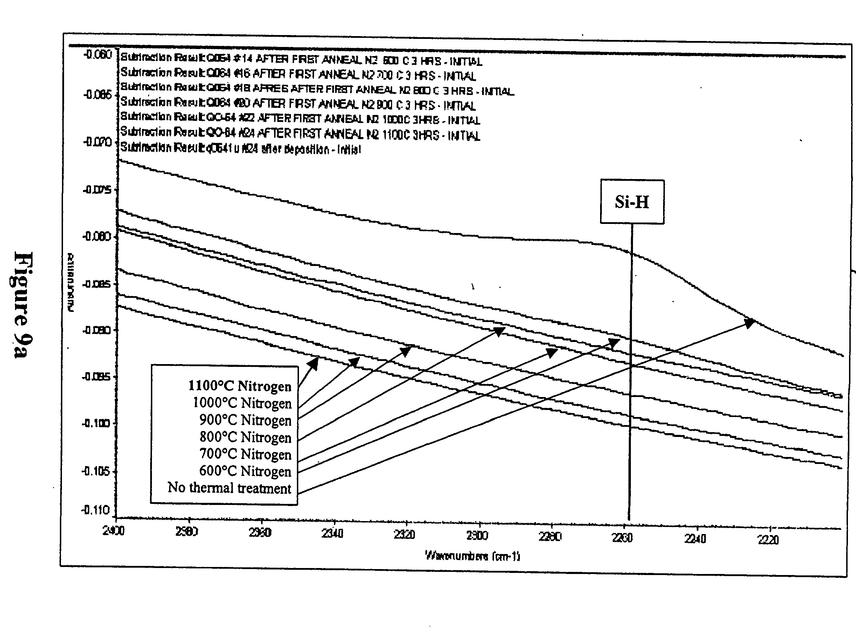

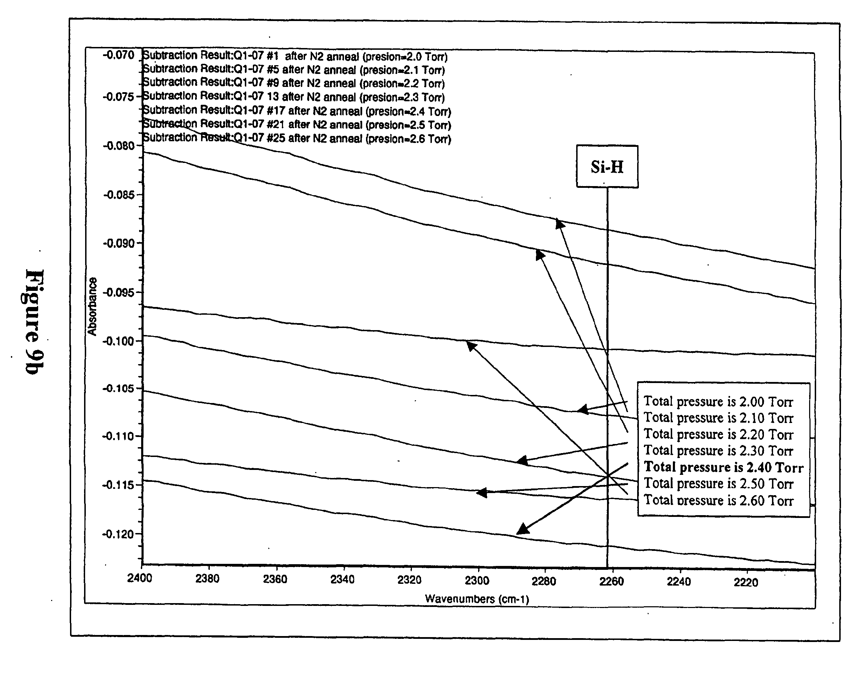

Figure 9a shows the in-depth FTIR spectra from 2200 to 2400 cm⁻¹ of typically deposited PECVD silica films before and after a three hours long high temperature thermal treatment in a nitrogen ambient at a temperature of either 600, 700, 800, 900, 1000 or 1100°C. This region of interest focuses on the Si-H oscillators, centered at 2260 cm⁻¹ of three (3) of the six (6) residual potential post-treatment compounds: SiNH, SiOH₂, and SiONH. It is dear that the higher the thermal decomposition temperature of the high temperature thermal treatment in a nitrogen ambient, the better the elimination of Si-H oscillators (which third harmonics could cause an optical absorption between 1.443 and 1.508 µm) with a complete elimination of residual Si-H oscillators (i.e. some configurations of the residual potential SiNH, SiOH₂, and SiONH post-treatment compounds) after a thermal treatment beyond 600°C in a nitrogen ambient.

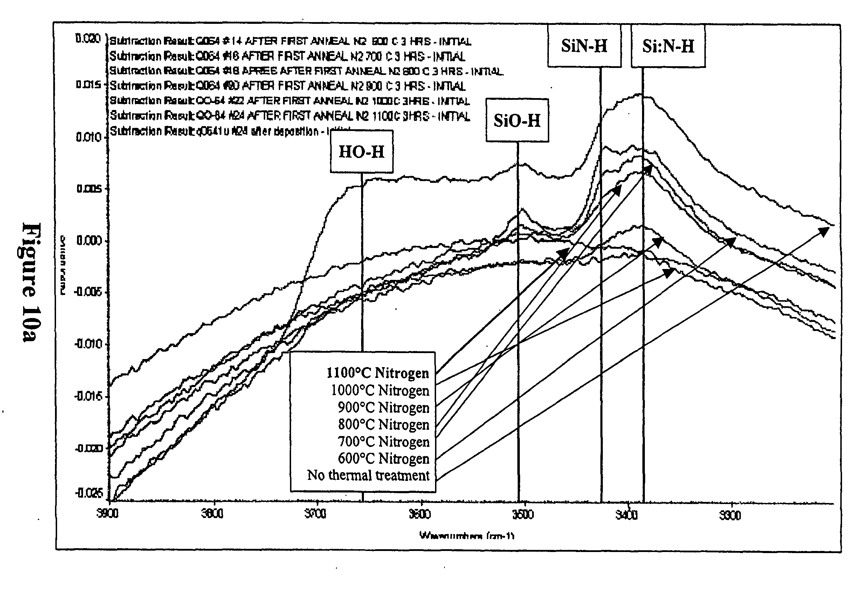

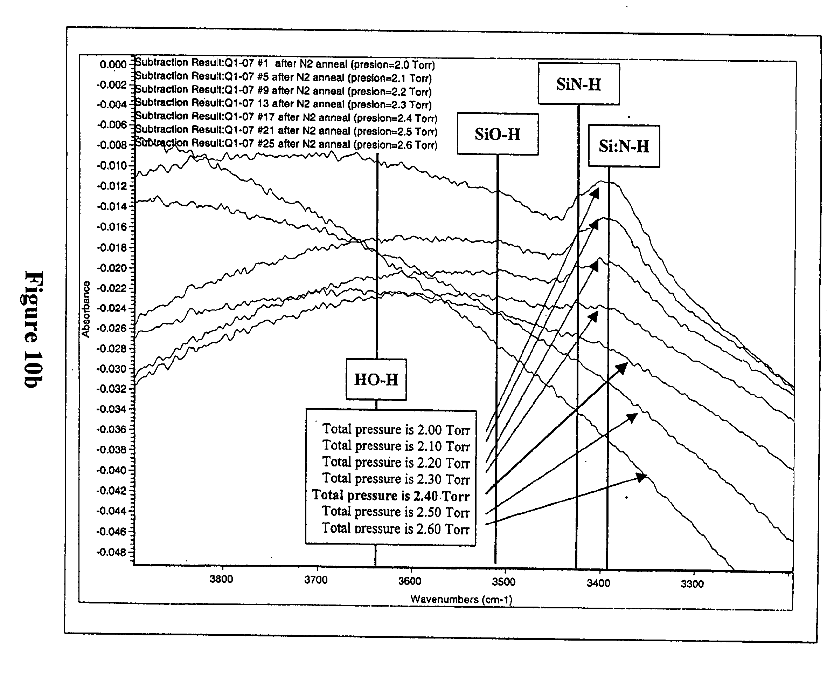

Figure 10a shows the in-depth FTIR spectra from 3200 to 3900 cm-¹ of typically deposited PECVD silica films before and after a three hours long high temperature thermal treatment in a nitrogen ambient at a temperature of either 600, 700, 800, 900, 1000 or 1100°C. This region of interest focuses on the Si:N-H oscillators, centered at 3380 cm⁻¹, the SiN-H oscillators, centered at 3420 cm⁻¹, the SiO-H oscillators, centered at 3510 cm-¹ and the HO-H oscillators, centered at 3650 cm⁻¹ of three (3) of the six (6) residual potential post-treatment compounds: SiNH, SiOH₂ and SiONH. It is clear that the higher the thermal decomposition temperature of the high temperature thermal treatment from 600 to 1100°C in a nitrogen ambient, the better the elimination of:
■ The HO-H oscillators (trapped water vapour in the micro-pores of the silica films and which second harmonics could cause an optical absorption between 1.333 and 1.408 µm) with a complete elimination over 600°C;
■ The SiO-H oscillators (which second harmonics could cause an optical absorption between 1.408 and 1.441 µm) with a complete elimination over 900°C;
■ The SiN-H oscillators (which second harmonics could cause an optical absorption between 1.445 and 1.479 µm)) with a complete elimination over 1000°C;
■ The Si:N-H oscillators (which second harmonics could cause an optical absorption between 1.445 and 1.515 µm) with are not yet completely eliminated at 1100°C. The complete elimination of the Si:N-H oscillators is extremely difficult because the nitrogen atom is bonded to the silicon atom of the SiO₂ network with two covalent bonds.

The upper Figure 7a to Figure 10a show that it is very difficult to completely eliminate the residual oscillators of the various undesirable Si-Oₓ-H_{y}-N_{z} potential post-treatment compounds and achieve optical quality silica films from typically deposited PECVD silica films using thermal treatments at temperature between 600 and 1100°C in a dry (nitrogen) ambient.

The improved Plasma Enhanced Chemical Vapour Deposition technique of silica films results in a better elimination of the undesirable residual Si:N-H oscillators (observed as a FTIR peak centered at 3380 cm⁻¹) after thermal treatments at lower post-deposition temperature and provide improved optical quality silica waveguides with reduced optical absorption of in the 1.30 to 1.55 µm optical region in order to use them in the fabrication of high performance optical quality Multiplexers (Mux) and Demultiplexers (Dmux) with improved performances in the 1.30 bi-directional narrow optical band and/or in the 1.55 µm video signal optical band.

Figure 5b shows the basic FTIR spectra of silica films obtained with the improved PECVD deposition technique after a three hours long high temperature thermal treatment in a nitrogen ambient at a low temperature of 800°C. It is clear that the control of the deposition pressure of this improved PECVD deposition technique has a major effect on the FTIR spectra of the treated silica films (i.e. the better the four basic optical absorption peaks):
■ A gradually more intense and smaller FWHM Si-O-Si "rocking mode" absorption peak (between 410 and 510 cm⁻¹) as the deposition pressure is increased from 267Pa (2.00 Tor)r up to an optimum 320 Pa (2.40 Torr) and then a gradually less intense and larger FWHM Si-O-Si "rocking mode" absorption peak as the pressure is further increased from the optimum 320 Pa (2.40 Torr) up to 347 Pa (2.60 Torr);
■ A slightly more intense and slightly smaller FWHM Si-O-Si "bending mode" absorption peak (between 740 and 880 cm⁻¹) can be obtained at an optimum deposition pressure of 320 Pa (2.40 Torr);
■ A gradually more intense and smaller FWHM Si-O-Si "in-phase-stretching mode" absorption peak (between 1000 and 1160 cm⁻¹) indicating a much more stoichiometric silica films with the optimum density and optimum Si-O-Si bond angle of 144°) as the deposition pressure is increased from 267 Pa (2.00 Torr) up to an optimum 320Pa (2.40 Torr) and then a gradually less intense and FWHM Si-O-Si "in-phase-stretching mode" absorption peak as the pressure is further increased from the optimum 320 Pa (2.40 Torr) up to 347 Pa (2.60 Torr);
■ A gradually more evident separation between the Si-O-Si "in-phase-stretching mode" absorption peak (1080 cm⁻¹) and the Si-O-Si "bending mode" absorption peak (810 cm⁻¹) with a gradually deeper valley between 850 and 1000 cm⁻¹ as the deposition pressure is increased from 267 Pa (2.00 Torr) up to an optimum 320 Pa (2.40 Torr) and then a gradually less evident separation and a gradually less deep valley between 850 and 1000 cm⁻¹ as the pressure is further increased from the optimum 320 Pa (2.40 Torr) up to 347 Pa (2.60 Torr);

An in-depth examination of some infrared regions of the FTIR spectra of Figure 5b with the help of the FTIR regions of the table of Figure 4 could help verifying the gradual elimination of the various Si-Oₓ-H_{y}-N_{z} potential as-deposited compounds and verify the gradual achievement of pure SiO₂ with minimum optical absorption in the 1.30 to 1.55 µm optical bands as the pressure is changed around this optimum deposition pressure of 320 Pa (2.40 Torr).

Figure 6b shows the in-depth FTIR spectra from 810 to 1000 cm-1 of silica films obtained with the improved PECVD deposition technique after a three hours long high temperature thermal treatment in a nitrogen ambient at a low temperature of 800°C. This region of the FTIR spectra should show a net separation between the Si-O-Si "in-phase-stretching mode" absorption peak (1080 cm⁻¹) and the Si-O-Si "bending mode" absorption peak (810 cm⁻¹) and should show a deep valley between 850 and 1000 cm⁻¹. It is clearly observed that there is a gradual elimination of the residual Si-OH oscillators (centered at 885 cm⁻¹) of the residual SiOH₂ residual post-treatment compound (Figure 3) as the deposition pressure is increased from 267 Pa(2.00 Torr) up to the optimum pressure of 320 Pa (2.40 Torr) and that the elimination gradually gets worse as the pressure is further increased from the optimum 320 Pa (2.40 Torr) up to 347 Pa (2.60 Torr). Similarly, it is clearly observed that there is a gradual elimination of the Si-ON oscillators (centered at 950 cm⁻¹) of the residual SiONH and/or SiON₂ post-treatment compounds (Figure 3) as the deposition pressure is increased from 267 Pa (2.00 Torr) up to the optimum 320 Pa (2.40 Torr) and then gradually less effective as the deposition pressure is further increased from this optimum 320 Pa (2.40 Torr) up to 347 Pa (2.60 Torr). The optimum separation and deep valley observed at 320 Pa (2.40 Torr) is an indication that the silica films resulting from this optimum deposition pressure are composed of high quality SiO₂ material.

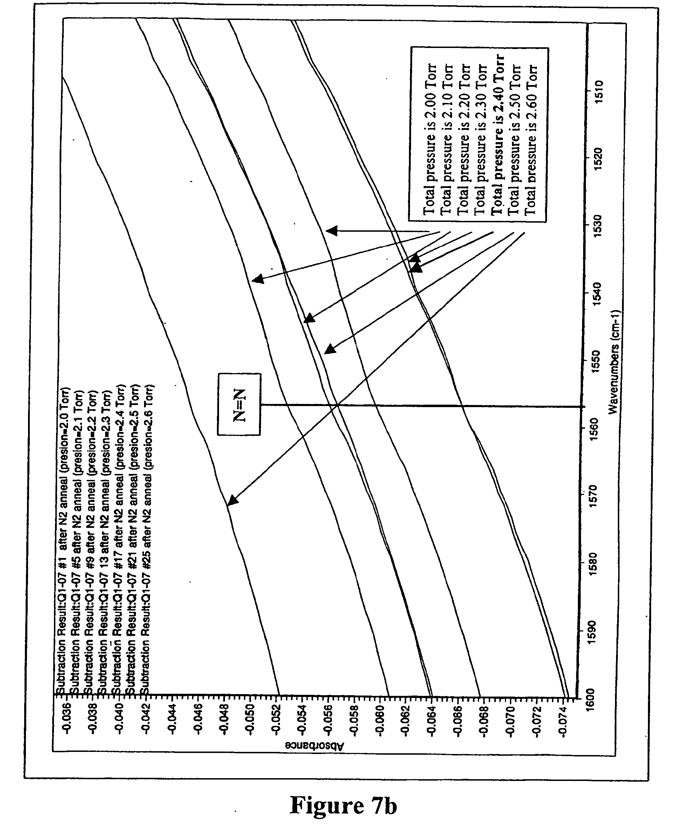

Figure 7b shows the in-depth FTIR spectra from 1500 to 1600 cm⁻¹ of silica films obtained with the improved PECVD deposition technique after a three hours long high temperature thermal treatment in a nitrogen ambient at a low temperature of 800°C. This region focuses on the N=N oscillators (centered at 1555 cm⁻¹ and which fifth harmonics could cause an optical absorption between 1.266 and 1.307 µm) of the various residual post-treatment compounds of Figure 4. It is observed that these oscillators are gradually eliminated as the deposition pressure is increased from 2.00 up to the optimum pressure of 320 Pa (2.40 Torr) and that the elimination is gradually (slight effect) less complete as the pressure is further increased from this optimum pressure of 320 - 347 Pa (2.40 up to 2.60 Torr).

Figure 8b shows the in-depth FTIR spectra from 1700 to 2200 cm⁻¹ of silica films obtained with the improved PECVD deposition technique after a three hours long high temperature thermal treatment in a nitrogen ambient at a low temperature of 800°C. This region focuses on the Si=O oscillators (centered at 1875 cm⁻¹) and on the unknown oscillator (centered at 2010 cm⁻¹) of the various residual post-treatment compounds described by Figure 4. It seems that even at the optimum deposition pressure of 320 Pa (2.40) Torr, it is not possible to eliminate the Si=O oscillators (which fourth harmonics could cause an optical absorption between 1.282 and 1.389 µm) and the unknown oscillators (which does not have a higher harmonics which could cause optical absorption in the 1.30 to 1.55 µm optical bands) at any of the deposition pressures. This limitation is not that important since only the fourth harmonics of the Si=O oscillators which can absorb in the 1.30 to 1.55 µm optical bands.

Figure 9b shows the in-depth FTIR spectra from 2200 to 2400 cm⁻¹ of silica films obtained with the improved PECVD deposition technique after a three hours long high temperature thermal treatment in a nitrogen ambient at a low temperature of 800°C. This region focuses on the Si-H oscillators (centered at 2260 cm⁻¹) of the various residual post-treatment compounds of Figure 3. It is clear that the Si-H oscillators (which third harmonics could cause an optical absorption between 1.443 and 1.508 µm) are completely eliminated for all deposition pressures.

Figure 10b shows the in-depth FTIR spectra from 3200 to 3900 cm⁻¹ of silica films obtained with the improved PECVD deposition technique after a three hours long high temperature thermal treatment in a nitrogen ambient at a low temperature of 800°C. This region focuses on the Si:N-H oscillators (centered at 3380 cm⁻¹), on the SiN-H oscillators (centered at 3420 cm⁻¹), on the SiO-H oscillators (centered at 3510 cm⁻¹) and on the HO-H oscillators (centered at 3650 cm⁻¹) of the various residual post-treatment compounds described by Figure 3. It is clear that all these oscillators are gradually eliminated as the deposition pressure is increased from 267 - 347 Pa (2.00 to 2.60 Torr).
■ The HO-H oscillators (trapped water vapour in the micro-pores of the silica films and which second harmonics could cause an optical absorption between 1.333 and 1.408 µm) are completely eliminated for all deposition pressures;
■ The SiO-H oscillators (which second harmonics could cause an optical absorption between 1.408 and 1.441 µm) are completely eliminated for all deposition pressures;
■ The SiN-H oscillators (which second harmonics could cause an optical absorption between 1.445 and 1.479 µm) are gradually eliminated as the deposition pressure is increased from 267 - 347 Pa (2.00 Torr to 2.60 Torr) ;
■ The Si:N-H oscillators (which second harmonics could cause an optical absorption between 1.445 and 1.515 µm are gradually eliminated as the deposition pressure is increased from 267 Pa (2.00 Torr) to 347 Pa (2.60 Torr). This complete elimination at such a low thermal treatment temperature of only 800°C is really spectacular because it requires thermally breaking two covalent bonds binding the nitrogen atom to the silicon atom of the SiO₂ network. It is to be concluded that the increase of deposition pressure from 267 Pa (2.00 Torr) to 347 Pa (2.60 Torr) minimizes the formation of such residual Si:N-H oscillators with two covalent bonds. By looking at Figure 1 and Figure 3 it appears that this gradual increase of deposition pressure from is 267 - 347 Pa (2.00 to 2.60) Torr may gradually prevent the formation of as deposited residual SiONH, SiONH₃, SiON₃H and SiON₃H₃ compounds which would result in the residual SiONH post-treatment compound responsible of the residual Si:N-H oscillators after thermal treatment.

A systematic comparison between: (Figures 5a and 5b), (Figures 6a and 6b), (Figures 7a and 7b), (Figures 8a and 8b), (Figures 9a and 9b) as well as (Figures 10a and 10b) shows the spectacular benefits of the improved PECVD deposition technique which results in a substantially total elimination of the various undesirable Si-Oₓ-H_{y}-N_{z} potential post-treatment compounds after a low temperature (800°C) thermal treatment in a nitrogen ambient and in particular of the residual SiONH post-treatment compounds which can still be detected by the residual Si:N-H oscillators (centered at 3380 cm⁻¹ and which second harmonics causes an optical absorption between 1.445 and 1.515 µm) of Figure 10a's 1100°C curve. By contrast, it is clear that these residual Si:N-H oscillators are completely eliminated from Figure 10b's 320 Pa (2.40 Torr) curve, even after a much lower temperature (800°C) thermal treatment in the same nitrogen ambient.

The improved Plasma Enhanced Chemical Vapour Deposition technique of silica films results in a better elimination of the undesirable residual Si:N-H oscillators (observed as a FTIR peak centered at 3380 cm⁻¹) after thermal treatment at lower post-deposition temperature so as to provide improved optical quality silica waveguides with reduced optical absorption of in the 1.30 to 1.55 µm optical region in order to use them in the fabrication of high performance optical quality Multiplexers (Mux) and Demultiplexers (Dmux) with improved performances in the 1.30 bi-directional narrow optical band and/or in the 1.55 µm video signal optical band.

The comparison of the various PECVD approaches summarised in Table 1 shows that the novel PECVD approach has a number of advantages: it does not require the use of B and/or P; it does not use TEOS; it does not use O₂; it does not use CF₄; it does not use SiH₄, N₂O and NH₃ gas mixtures; it does not use SiH₄, N₂O and Ar gas mixtures; it does use more then just SiH₄ and N₂O gas mixtures; and while it does use SiH₄, N₂O and N₂ gas mixtures, it does so in a very different way from the cited prior art (Imoto K., 1993) which only reports the control of the mass flow rates of the three gases as a way to control the transparency and refractive index of the silica film.

The described technique uses an independent control of the SiH₄, N₂O and N₂ gases as well as of the total deposition pressure via an automatic control of the pumping speed of the vacuum pump. As mentioned before the fundamental principles of classical thermodynamics predict that the equilibrium constants of the various chemical reactions of Figure 2 will be affected by the total deposition pressure and will result in an improved elimination of some of thirty-five (35) Si-Oₓ-H_{y}-N_{z} potential as-deposited compounds due to an improved elimination of N₂, O₂, HNO, NH₃, H₂O, and H₂ gaseous compounds that must be eliminated from the micro-pores of the growing silica films up to their surface and from their surface through the gaseous boundary layer present near their surface. This effect is due to the fact that many of the chemical reactions of Figure 3 are associated with a modification of the number of gaseous compounds; i.e. the number of gaseous product compound molecules is different then three, the number of gaseous reactant compound molecules:

SiH₄(g) + 2N₂O(g) → The various products of Figure 3

In other words, unlike the various cited references which use: SiH₄/N₂O gas flow ratios in a two-dimensional space (a unique independent variable, the SiH₄/N₂O ratio, and the observed variable, the observed film characteristics); or SiH₄/N₂O/N₂ gas flow ratios in a three-dimensional space (a first independent variable, the SiH₄/N₂O ratio, a second independent variable, N₂O/N₂ ratio, and the observed variable, the observed film characteristics); SiH₄, N₂O, N₂ gas flows in a four-dimensional space (a first independent variable, the SiH₄ flow, a second independent variable, the N₂O flow, a third independent variable the N₂ flow, and the observed variable, the observed film characteristics); the technique described in this patent application uses a five-dimensional space (a first independent variable, the SiH₄ flow, a second independent variable, the N₂O flow, a third independent variable the N₂ flow, a fourth independent variable, the total deposition pressure (controlled by an automatic adjustment of the pumping speed), and the observed variable, the observed film characteristics) to optimize the silica films characteristics.

The spectacular effect of the total deposition pressure was demonstrated by the FTIR spectra of: Figure 4b, Figure 5b, Figure 6b, Figure 7b, Figure 8b and Figure 9b which compare the results of silica films deposited at the following fixed gas flows:
■ The first independent variable, the SiH₄ gas flow, was fixed at 0.20 std liter/min;
■ The second independent variable, the N₂O gas flow, was fixed at 6.00 std liter/min;
■ The third independent variable, the N₂ gas flow, was fixed at 3.15 std liter/min.

Only the fourth independent variable, the total deposition pressure, was varied:
■ Total deposition pressure of 267 Pa (2.00 Torr);
■ Total deposition pressure of 280 Pa (2.10 Torr);
■ Total deposition pressure of 292 Pa (2.20 Torr);
■ Total deposition pressure of 307 Pa (2.30 Torr);
■ Total deposition pressure of 320 Pa (2.40 Torr);
■ Total deposition pressure of 333 Pa (2.50 Torr);
■ Total deposition pressure of 347 Pa (2.60) Torr;

The spectacular effect of this fourth independent variable, the total deposition pressure, on the elimination of the various undesirable Si-Oₓ-H_{y}-N_{z} potential post-treatment compounds after a low temperature (800°C) thermal treatment in a nitrogen ambient is clearly demonstrated by comparing: (Figures 5a and 5b), (Figures 5a and 5b), (Figures 6a and 6b), (Figures 7a and 7b), (Figures 98a and 8b) as well as (Figures 9a and 9b). In particular, it is demonstrated that the residual Si:N-H oscillators of the residual SiONH post-treatment compounds (centered at 3380 cm⁻¹ and which second harmonics causes an optical absorption between 1.445 and 1.515 µm) are completely eliminated from Figure 10b's 347 Pa (2.60 Torr) curve even after a low temperature thermal treatment of only 800°C in nitrogen. This contrasts with the results of Figure 10a which shows that a much higher temperature thermal treatment of 1100°C in nitrogen is required to eliminate the same oscillators from silica films obtained from typical non-optimized PECVD conditions.

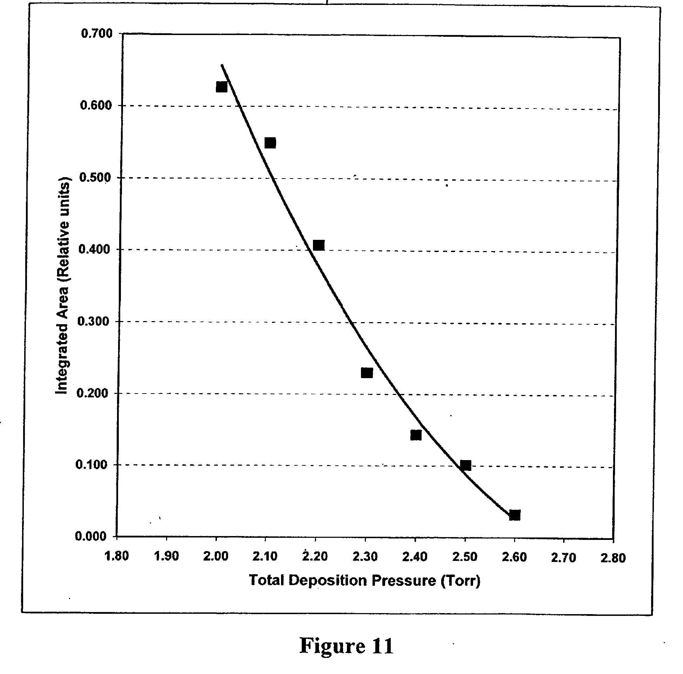

Figure 11 summarises the spectacular effect of this fourth independent variable, the total deposition pressure, on the integrated area under the 3380 cm-1 FTIR peak of the Si:N-H oscillators of PECVD silica films deposited at a fixed SiH₄ gas flow of 0.20 std liter/min, at a fixed N₂O gas flow of 6.00 std liter/min and at a fixed N₂ gas flow of 3.15 std liter/min and following a thermal treatment in a nitrogen ambient at 800°C.

The elimination of the residual Si:N-H oscillators at lower temperature is not the only benefit of the technique described in this patent application.

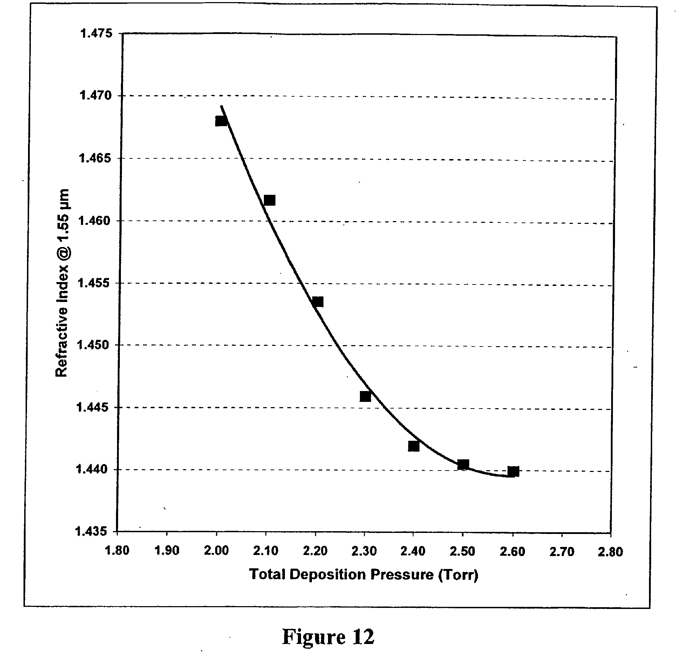

Figure 12 shows the effect of the total deposition pressure on the 1.55 µm refractive index of PECVD silica films deposited at a fixed SiH₄ gas flow of 0.20 std liter/min, at a fixed N₂O gas flow of 6.00 std liter/min and at a fixed N₂ gas flow of 3.15 std liter/min and following a thermal treatment in a nitrogen ambient at 800°C. It is again clear that the introduction of the fourth independent variable, the total deposition pressure, is critical for the development of optimized optical silica films. The refractive index at the operation wavelength of 1.55 µm is certainly one of the most important film characteristic. This Figure 12 dearly indicates that the control of this parameter is of prime importance for the repeatable achievement of high quality optical silica films. At this point it should be noted that typical vacuum pumping systems used in PECVD equipment (i.e. rotary vane mechanical pumps, roots blowers, turbo-molecular pumps or others) suffer from many sources of pumping speed variation over time (variation of the AC electrical power source, variation of the pumping conductance due to accumulation of residues in the protection scrubber or pumping lines etc) and it is then expected that a PECVD deposition condition involving a fixed set of gas flow parameters will suffer from a non-repeatability of the observed film characteristics.

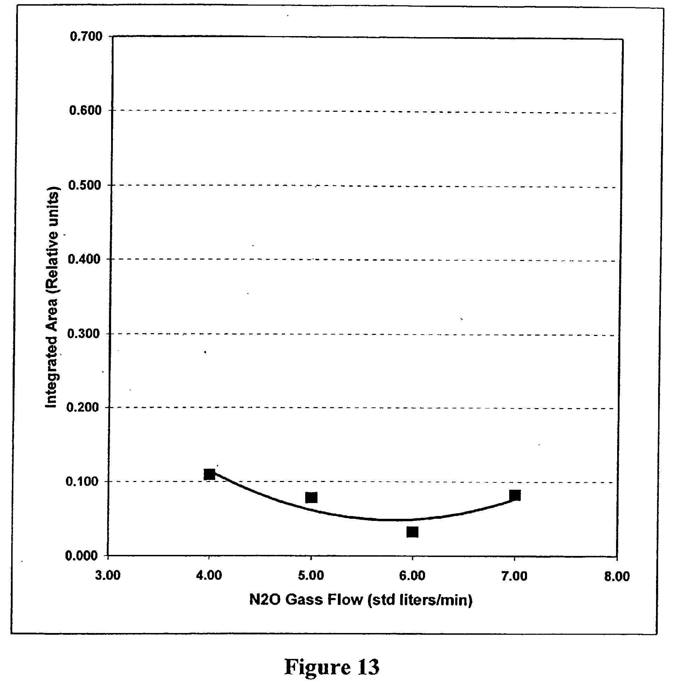

Figure 13 summarises the effect of the N₂O mass flow rate on the integrated area under the 3380 cm⁻¹ FTIR peak of the Si:N-H oscillators of PECVD silica films deposited at a fixed SiH₄ gas flow of 0.20 std liter/min, at a fixed N2 gas flow of 3.15 std liter/min, at a fixed total deposition pressure of 347 Pa (2.60 Torr) and following a thermal treatment in a nitrogen ambient at 800°C. It is very clear that once the local optimum operation point is found in the five dimensional space (four independent variables and one output measurement), there might be no further relationship between the residual optical absorption of the obtained silica films and that the SiH₄-to-N₂O gas flow ratio is actually not a determining factor. Again, since the optical transparency at the operation wavelength of 1.55 µm is certainly one of the most important film characteristic of optical silica waveguides, this Figure 13 clearly indicates that, unlike for what is reported in the previous art literature, the SiH₄-to-N₂O gas flow ratio is not an important factor in the definition of the optical properties of silica films.

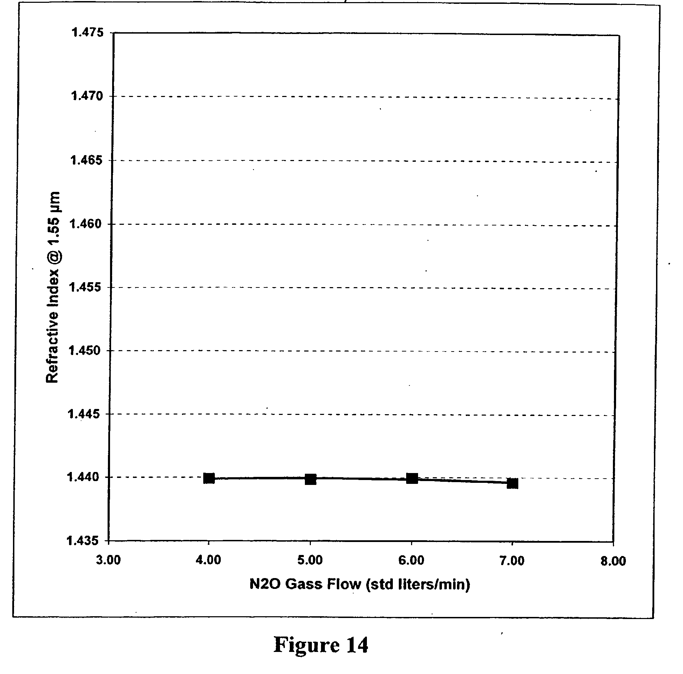

Figure 14 shows the effect of the N2O gas flow on the 1.55 µm refractive index of PECVD silica films deposited at a fixed SiH₄ gas flow of 0.20 std liter/min, at a fixed N₂ gas flow of 3.15 std liter/min, at a fixed total deposition pressure of 347 Pa (2.60 Torr) and following a thermal treatment in a nitrogen ambient at 800°C. It is again very dear that once the local optimum operation point is found in the five dimensions space (four independent variables and one output measurement), there might be no more relationship between the measured film characteristics and the ratio of SiH₄-to-N₂O gas flow ratio. Again, since the refractive index at the operation wavelength of 1.55 µm is certainly one of the most important film characteristic of optical silica waveguides, this Figure 14 clearly indicates that the SiH₄-to-N₂O gas flow ratio is not a critical factor in the definition of the optical properties of silica films.

It will be appreciated by persons skilled in the art that a number of variants of the invention as described are possible. Purely, by way of non-limiting example, the PECVD silica films could be deposited with some molecules incorporating Phosphorus, Boron, Germanium, Titanium or Fluorine to modify the refractive index of the optimized films. The PECVD silica films could be deposited at a temperature different from 400°C. It could be deposited at any temperature between 100 and 650°C.

The PECVD equipment could be different from the Novellus Concept One. The requirement is to provide independent control of the four basic control parameters: SiH₄ gas flow rate, N₂O gas flow rate, N₂ gas flow rate and total deposition pressure.

The found local optimum (SiH₄ gas flow of 0.20 std liter/min, N₂O gas flow of 6.00 std liter/min, N₂ gas flow of 3.15 std liter/min and a total deposition pressure of 320 Pa (2.40 Torr) is this four-independent-variables space. A different set of coordinates (SiH₄, N₂O, N₂, deposition pressure) could be found using the same Novellus Concept One equipment.

A different set of coordinates (SiH₄, N₂O, N₂, deposition pressure) could be found for another type of PECVD equipment.

The high temperature thermal treatment in nitrogen could be performed at a temperature different to 800°C. The range is from 400 to 1200°C.

The described invention thus results in a Plasma Enhanced Chemical Vapour Deposition technique of silica films that results in a better elimination of the undesirable residual Si:N-H oscillators (observed as a FTIR peak centered at 3380 cm⁻¹) after thermal treatments at lower post-deposition temperature to provide improved optical quality silica waveguides with reduced optical absorption of in the 1.30 to 1.55 µm optical region in order to use them in the fabrication of high performance optical quality Multiplexers (Mux) and Demultiplexers (Dmux) with improved performances in the 1.30 bi-directional narrow optical band and/or in the 1.55 µm video signal optical band.

The optical region of interest is not limited to the 1.30 to 1.55 µm optical region since the higher oscillation harmonics of the eliminated oscillators have other optical benefits at longer or shorter wavelengths. The wavelengths of the first, second, third and fourth harmonics of these oscillators are also included in the invention.

The invention has application in any manufacturing processes involving the use of high quality silica films, such as: Photonics devices other than Mux/Dmux devices; Semiconductor devices; Micro Electro Mechanical Systems (MEMS); Bio-chips; Lab-on-a-chip devices; and Multi-chip modules.

## Claims

1. A method of depositing an optical quality silica film on a substrate, wherein said optical quality silica film is deposited on said substrate by plasma enhanced chemical vapor deposition (PECVD) at a temperature between 100 and 650°C in the presence of SiH₄, N₂O and N₂ gases,
**characterized in that**:
a) the flow rates of said SiH₄ N₂O and N₂ gases are controlled at predetermined fixed values;
b) silica films are deposited on said substrate at different total deposition pressures varying between 267 - 347 Pa (2.0 and 2.6 Torr);
c) the optical absorption and/or refractive index of the deposited silica films are observed to determine the optimum total deposition pressure;
d) the optical quality silica film is deposited while controlling said total deposition pressure to said optimum total deposition pressure determined in step c; and
e) the deposited optical quality silica film is subjected to a low temperature treatment between 400° and 1200°C to minimize the presence of contaminant compounds in said film.

2. A method as claimed in claim 1, **characterized in that** the deposited optical quality silica film is subjected to a low temperature treatment ate 800°C.

3. A method as claimed in claim 1 or 2, **characterized in that** the total gas pressure is 320 Pa (2.4 Torr).

4. A method as claimed in claim 1, 2 or 3, **characterized in that** the silica film is deposited in a vacuum chamber whose pressure is maintained by a vacuum pump having a controllable pumping speed, and the total gas pressure is maintained by controlling said pumping speed.

5. A method as claimed in claim 1, **characterized in that** the silica film is deposited at a temperature of 400°C.

6. A method as claimed in any preceding claim, **characterized in that** the flow rate of the SiH₄ gas is 0.2 std liter/min.

7. A method as claimed in any preceding claim, **characterized in that** the flow rate of the N₂O gas is 6.00 std liter/min.

8. A method as claimed in any preceding claim, **characterized in that** the flow rate of the N₂ gas is 3.15 std liter/min.

9. A method as claimed in any preceding claim, **characterized in that** a modifier is incorporated into the silica film during deposition to modify the resulting refractive index.

10. A method as claimed in claim 10, **characterized in that** said modifier is selected from the group consisting of: Phosphorus, Boron, Germanium, Titanium and Fluorine.

## Patentansprüche

1. Verfahren zur Beschichtung von Trägermaterialen mit einer Siliciumoxidschicht optischer Qualität, wobei die Siliciumoxidschicht optischer Qualität durch das chemische Aufdampfen mit Plasma-Unterstützungs-Verfahren *(PECVD - Plasma Enhanced Chemical Vapor Deposition)* bei einer Temperatur zwischen 100°C und 650°C in der Gegenwart von SiH₄, N₂O et N₂ Gasen auf das Trägermaterial abgelagert wird, **dadurch gekennzeichnet, daß**:
a) die Durchflußraten von SiH₄, N₂O und N₂ Gasen bei vorbestimmten festen Werten gesteuert werden;
b) die Siliciumoxidschichten auf das Trägermaterial unter verschiedenen Gesamtablagerungsdrücken zwischen 267 und 347 Pa (2,0 et 2,6 Torr) abgelagert werden;
c) die optische Absorption und/oder der Brechungsindex der abgelagerten Siliciumoxidschicht beobachtet werden, um den optimalen Gesamtablagerunsdruck zu bestimmen, und
d) während der Ablagerung der Siliciumoxidschicht optischer Qualität der Gesamtablagerungsdruck auf dem im Schritt c bestimmten optimalen Gesamtablagerunsdruck gehalten wird, und
e) die abgelagerte Siliciumoxidschicht optischer Qualität einer Bearbeitung bei niedrigen Temperaturen zwischen 400°C. und 1200°C unterzogen wird, um das Vorhandensein von Fremdstoffverbindungen in der Schicht zu minimalisieren.

2. Verfahren nach Anspruch 1, **dadurch gekennzeichnet, daß** die abgelagerte Siliciumoxidschicht optischer Qualität einer Bearbeitung bei einer niedrigen Temperatur von 800°C unterzogen wird.

3. Verfahren nach Anspruch 1 oder 2, **dadurch gekennzeichnet, daß** der Gesamtgasdruck 320 Pa (2,4 Torr) ist.

4. Verfahren nach Anspruch 1, 2 oder 3, **dadurch gekennzeichnet, daß** die Siliciumoxidschicht in einer Vakuumkammer abgelagert wird, deren Druck durch eine Vakuumpumpe mit steuerbarer Pumpgeschwindigkeit und der Gesamtgasdruck durch die Steuerung der Pumpgeschwindigkeit gehalten wird.

5. Verfahren nach Anspruch 1, **dadurch gekennzeichnet, daß** die Siliciumoxidschicht bei einer Temperatur von 400°C abgelagert wird.

6. Verfahren nach einem der vorangehenden Ansprüche, **dadurch gekennzeichnet, daß** die Durchflußrate des SiH₄-Gases 0,2 1/min ist.

7. Verfahren nach einem der vorangehenden Ansprüche, **dadurch gekennzeichnet, daß** die Durchflußrate des N₂O-Gases 6,00 1/min ist.

8. Verfahren nach einem der vorangehenden Ansprüche, **dadurch gekennzeichnet, daß** die Durchflußrate des N₂-Gases 3,15 1/min ist.

9. Verfahren nach einem der vorangehenden Ansprüche, **dadurch gekennzeichnet, daß** während der Ablagerung ein Modifikator in die Siliciumoxidschicht eingelagert wird, um den resultierenden Bruchindex zu modifizieren.

10. Verfahren nach Anspruch 9, **dadurch gekennzeichnet, daß** der Modifikator aus einer Gruppe ausgewählt wird, die aus Phosphor, Bor, Germanium, Titan und Fluor besteht.

## Revendications

1. Méthode servant à déposer une pellicule de silice de qualité optique sur un substrat, dans laquelle ladite pellicule de silice de qualité optique est déposée sur ledit substrat par dépôt chimique en phase vapeur activé par plasma (DCPVAP) à une température entre 100 et 650 °C en présence des gaz SiH₄, N₂O et N₂, **caractérisée en ce que** :
a) les débits des gaz SiH₄, N₂O et N₂ sont contrôlés à des valeurs fixes déterminées à l'avance;
b) les pellicules de silice sont déposées sur ledit substrat à différentes pressions de dépôt total variant entre 267 et 347 Pa (2,0 et 2,6 Torr);
c) l'absorption optique et/ou l'indice de réfraction des pellicules de silice déposées sont observés pour qu'on détermine la pression de dépôt total optimale;
d) la pellicule de silice de qualité optique est déposée pendant qu'on contrôle ladite pression de dépôt total à ladite pression de dépôt total optimale déterminée à l'avance à l'étape c; et
e) la pellicule de silice de qualité optique déposée est assujettie à un traitement de basse température entre 400 et 1 200 °C afin de minimiser la présence de composés contaminants dans ladite pellicule.

2. Méthode selon la revendication 1, **caractérisée en ce que** la pellicule de silice de qualité optique déposée est assujettie à un traitement de basse température de 800 °C.

3. Méthode selon la revendication 1 ou 2, **caractérisée en ce que** la pression de gaz totale est de 320 Pa (2,4 Torr).

4. Méthode selon la revendication 1, 2 ou 3, **caractérisée en ce que** la pellicule de silice est déposée dans une chambre à vide dont la pression est maintenue par une pompe à vide dotée d'une vitesse de pompage contrôlable, et la pression totale du gaz est maintenue par le contrôle de ladite vitesse de pompage.

5. Méthode selon la revendication 1, **caractérisée en ce que** la pellicule de silice est déposée à une température de 400 °C.

6. Méthode selon l'une quelconque des revendications précédentes, **caractérisée en ce que** le débit du gaz SiH₄ est de 0,2 litre/min.

7. Méthode selon l'une quelconque des revendications précédentes, **caractérisée en ce que** le débit du gaz N₂O est de 6,00 litres/min.

8. Méthode selon l'une quelconque des revendications précédentes, **caractérisée en ce que** le débit du gaz N₂ est de 3,25 litres/min.

9. Méthode selon l'une quelconque des revendications précédentes, **caractérisée en ce qu'**un modificateur est incorporé à la pellicule de silice durant le dépôt afin de modifier l' indice de réfraction résultant.

10. Méthode selon la revendication 9, **caractérisée en ce que** ledit modificateur est choisi du groupe consistant en : phosphore, bore, germanium, titane et fluor.
